# EUROPEAN PATENT APPLICATION

(11) **EP 2 273 560 A1**
(43) Date of publication of application: **12.01.2011**
(21) Application number: 09738764.1
(22) Date of filing: 24.04.2009
(51) Int. Cl.: H01L 31/04, B32B 27/30

(54) **LAMINATE FOR SOLAR BATTERY BACK-SHEET, AND BACK-SHEET COMPRISING THE SAME**

(30) Priority: 28.04.2008 JP 2008117485
(71) Applicant: Asahi Kasei Chemicals Corporation, Tokyo 101-8101 (JP)
(72) Inventor: HAYASHI, Mikine, Tokyo 101-8101 (JP); AZUMA, Kouichirou, Tokyo 101-8101 (JP); MORI, Motoyoshi, Tokyo 101-8101 (JP); MURAKAMI, Masahiro, Ena-shi Gifu 509-7126 (JP)
(74) Representative: Strehl Schübel-Hopf & Partner
(86) International application number: PCT/JP2009/058208
(87) International publication number: WO 2009/133827

(57) **Abstract**

Provided is a laminate for a solar battery back-sheet, which is capable of exhibiting and maintaining an excellent water-vapor barrier property even under a severe natural environment for a long time, i.e., excellent in weather resistance and humidity resistance, and which is produced by laminating a vinylidene chloride-based resin layer and a silicone-modified acrylic-based resin layer.

## Description

### Technical Field

The present invention relates to a laminate for a solar battery back-sheet tolerable in a severe natural environment for a long time, a solar battery back-sheet comprising the laminate for the solar battery back-sheet and a solar battery module comprising the solar battery back-sheet.

### Background Art

Recently, a global heating issue has been of high concern in various fields inside and outside the country. In the circumstances, various efforts have been made to suppress discharge of carbon dioxide. An increase of fossil fuel consumption raises the level of carbon dioxide in the atmosphere. Due to the greenhouse effect thereof, global temperature increases and has a significant effect upon the global environment. Various studies have been made on alternative energy to fossil fuel. Expectation for photovoltaic power generation which is a clean energy source has been increased. A solar battery, which constitutes the heart of a photovoltaic power generation system for directly converting solar energy to electricity, is formed of a semiconductor. In the system, a solar battery element is not used singly as it is. Generally, several to several tens of solar battery elements are arranged in series or in parallel via wiring and packaged in various ways in order to protect the elements for a long time (about 20 years) as a unit. The unit incorporated in the package is called a solar battery module. Generally, a surface of the solar battery module to which sunlight is applied is covered with glass. The space is filled with a filler formed of a thermoplastic plastic (generally, an ethylene-vinyl acetate copolymer resin) and the rear surface is protected by a sheet of e.g., a heat resistant and weather resistant plastic material.

Since the solar battery module is used outside, the structure thereof and material structure are required to have sufficient tolerance and weather resistance. Particularly, a back-sheet (rear-surface protecting sheet) is required to have not only weather resistance but also low water-vapor permeability. This is because if water permeates, the filler may be removed and colored, and wiring may be eroded, with the result that output from the module itself may be affected.

The solar battery back-sheets that have been frequently used in the art have a structure in which a metal foil (generally, aluminum foil) having a gas-barrier property or an inorganic oxide deposited film (generally, aluminum-deposited polyethylene terephthalate (PET) film) is sandwiched by high weather resistant resin films such as polyvinyl fluoride film (fluorine films) or laminated on the high weather resistant resin film.
However, the fluorine film is not only poor in mechanical strength but also inferior in processability. In manufacturing the solar battery module, a protrusion of the electrode portion of the solar battery element passes through the fluoride film and comes into contact with the aluminum foil within the rear-surface protecting sheet; with the result that short circuit occurs between the solar battery element and the aluminum foil, disadvantageously affecting the performance of the battery. Furthermore, a complicated structure of a member formed of a plurality of layers is not desirable in view of productivity, preventing the spread of the solar battery.

To improve these drawbacks and obstructions, for example, a polyacryl film, a vinyl chloride film, a polyester film, a polycarbonate film, a polyvinylidene fluoride film and other various alternative films have been studied as the solar battery back-sheet.

Patent Literature 1 describes a back-sheet for a solar battery formed by laminating a polycarbonate film and a deposition film formed of an inorganic oxide.
Patent Literature 2 describes a back-sheet for a solar battery module, formed by laminating a pair of aluminum deposited layers on both surfaces of a polyethylene terephthalate film via an adhesive layer, which is formed of a dry-laminate adhesive using a polyurethane-based adhesive.
Patent Literature 3 describes a thermoplastic resin sheet for a solar battery comprising a thermoplastic resin layer such as a polyethylene terephthalate containing titanium dioxide.
Patent Literature 4 describes a sheet member for a solar battery, formed of a plurality of resin film layers and containing a polyethylene naphthalate film as the outer layer arranged relatively away from a solar battery module.
Patent Literature 5 describes a thin-film solar battery module characterized in that butyl rubber is used in the in-plane peripheral edge of a rear-surface protecting sheet used in a thin film solar battery module, aluminum foil is used as a moisture proof layer, and a base layer formed of PET film and the moisture proof layer are joined with a urethane resin-based adhesive.
Patent Literature 6 describes a rear-surface protecting sheet for a solar battery, using a laminate sheet comprising at least one polypropylene-based resin sheet layer and a sheet formed of a polyethylene-based resin on at least one of the surfaces of the polypropylene-based resin sheet.
Patent Literature 7 describes a rear-surface protecting sheet for a solar battery module, characterized by being formed of a three-layer laminate resin film formed by laminating heat resistant polypropylene-based resin films containing a UV ray absorbent and a photostabilizer, and a solar battery module using the same.

### Citation list

### Patent Literature

Patent Literature 1: Japanese Patent Application Laid-Open No. 2006-324556
Patent Literature 2: Japanese Patent Application Laid-Open No. 2005-322687
Patent Literature 3: Japanese Patent Application Laid-Open No. 2006-270025
Patent Literature 4: Japanese Patent Application Laid-Open No. 2006-179557
Patent Literature 5: Japanese Patent Application Laid-Open No. 2006-310680
Patent Literature 6: Japanese Patent Application Laid-Open No. 2004-223925
Patent Literature 7: Japanese Patent Application Laid-Open No. 2003-243679
Patent Literature 8: International Publication WO2008/043848

### Summary of Invention

### Problems to be Solved by the Invention

However, the laminates for the solar battery back-sheets described in Patent Documents 1-7, fail to sufficiently satisfy various functions such as heat resistance, weather resistance and humidity resistance and cannot maintain a high water-vapor barrier property under a severe natural environment for a long time. Therefore, it cannot be said that these laminates are desirable.
Furthermore, in the laminate described in Patent Literature 8 and having a gas-barrier property, at least two gas barrier layers are required in order to exhibit sufficient gas-barrier property. Besides this, the content disclosed therein, more specifically, water resistance and weather resistance, cannot be said to be desirable to be used in a solar battery member under a severe natural environment.

Then, a problem to be solved by the present invention is to provide a laminate for a solar battery back-sheet, which is capable of exhibiting and maintaining an excellent water-vapor barrier property even under a severe natural environment for a long time, i.e., excellent in weather resistance and humidity resistance.
Another problem is to provide a solar battery back-sheet comprising the laminate for the solar battery back-sheet, and provide a solar battery module comprising the solar battery back-sheet.

### Means for Solving the Problems

The present inventors have conducted intensive studies with a view to solving the above problems. As a result, they found that a laminate for a solar battery back-sheet, comprising a vinylidene chloride-based resin layer and a silicone-modified acrylic-based resin layer laminated on the vinylidene chloride-based resin layer can be used as an effective means for solving the above problems.
More specifically, the present invention provides a laminate for a solar battery back-sheet, a solar battery back-sheet comprising the laminate for the solar battery back-sheet, and a solar battery module comprising the solar battery back-sheet, which will be described below.
[1]
   A laminate for a solar battery back-sheet comprising:
   a vinylidene chloride-based resin layer; and
   a silicone-modified acrylic-based resin layer laminated on the vinylidene chloride-based resin layer.
[2]
   The laminate for the solar battery back-sheet according to item [1], in which the vinylidene chloride-based resin layer and the silicone-modified acrylic-based resin layer are laminated in direct contact with each other.
[3]
   The laminate for the solar battery back-sheet according to item [1] or [2], in which the vinylidene chloride-based resin layer is produced from a vinylidene chloride lacquer obtained by dissolving a vinylidene chloride-based resin powder in an organic solvent, or from a vinylidene chloride emulsion.
[4]
   The laminate for the solar battery back-sheet according to item [3], in which the vinylidene chloride-based resin powder in the vinylidene chloride lacquer and the vinylidene chloride emulsion are obtained by emulsion polymerization of a monomer containing not less than 50% by mass of vinylidene chloride based on the total amount of the monomer.
[5] The laminate for the solar battery back-sheet according to any one of items [1] to [4], in which the silicone-modified acrylic-based resin layer is produced from a silicone-modified acrylic emulsion.
[6]
   The laminate for the solar battery back-sheet according to item [5], in which the silicone-modified acrylic emulsion contains a silicone resin and an acrylic resin.
[7]
   The laminate for the solar battery back-sheet according to item [6], in which when the acrylic resin is produced by emulsion polymerization, the silicone-modified acrylic emulsion is obtained by adding a silicone modifier before the emulsion polymerization, during the emulsion polymerization or after the emulsion polymerization.
[8]
   The laminate for the solar battery back-sheet according to any one of items [5] to [7], in which a UV ray absorbent and/or a photostabilizer are blended in the silicone-modified acrylic emulsion.
[9]
   The laminate for the solar battery back-sheet according to any one of items [5] to [10], in which the silicone-modified acrylic emulsion is blended with a pigment and used as a paint.
[10]
   The laminate for the solar battery back-sheet according to any one of items [1] to [9], in which the vinylidene chloride-based resin layer is a coating layer with a vinylidene chloride lacquer or a vinylidene chloride emulsion and the silicone-modified acrylic-based resin layer is a coating layer with a silicone-modified acrylic emulsion.
[11]
   The laminate for the solar battery back-sheet according to item [10], in which a thickness of the vinylidene chloride-based resin coating layer is 5 to 50 µm and the thickness of the silicone-modified acrylic-based resin coating layer is 10 to 100 µm.
[12]
   A solar battery back-sheet comprising a base material and the laminate for the solar battery back-sheet according to any one of items [1] to [11], in which
   the laminate for the solar battery back-sheet is laminated on the base material.
[13]
   The solar battery back-sheet according to item [12], in which the base material is a plastic base material.
[14]
   The solar battery back-sheet according to item [12] or [13], in which the vinylidene chloride-based resin layer and the base material are laminated with an adhesive interposed between them.
[15]
   The solar battery back-sheet according to item [13] or [14], in which the plastic base material is formed of a polyethylene terephthalate-based resin.
[16]
   The solar battery back-sheet according to item [15], in which the polyethylene terephthalate-based resin is a hydrolysis resistant resin.
[17]
   A solar battery module comprising the solar battery back-sheet according to any one of items [12] to [16].

### Advantages of the Invention

According to the present invention, it is possible to provide a laminate for a solar battery back-sheet, which is capable of exhibiting and maintaining an excellent water-vapor barrier property under a severe natural environment for a long time, i.e., excellent in weather resistance and humidity resistance. Furthermore, it is possible to provide a solar battery back-sheet comprising the laminate for the solar battery back-sheet and a solar battery module comprising the solar battery back-sheet.

### Brief Description of Drawings

[Figure 1]

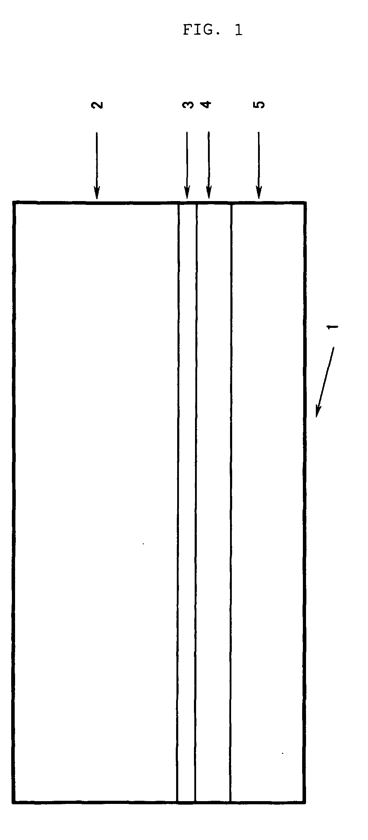

   Figure 1 shows a sectional view of a solar battery back-sheet.
[Figure 2]

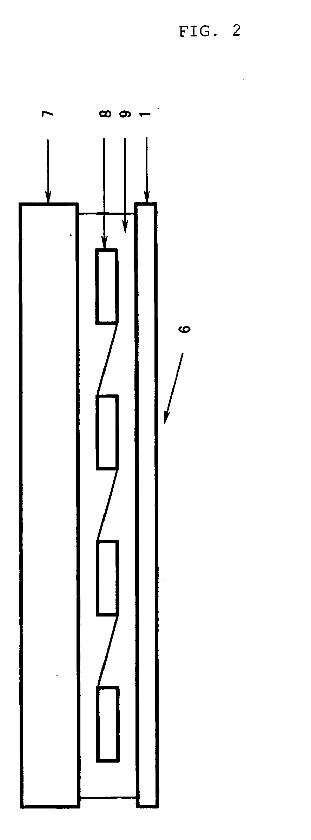

   Figure 2 shows a sectional view of a solar battery module.

### Mode for Carrying Out the Invention

A best mode for carrying out of the present invention (hereinafter referred to as "the present embodiment") will be more specifically described below. Note that the present invention is not limited to the embodiment below and can be modified in various ways within the range of the gist of the present invention.

### (Laminate for a solar battery back-sheet)

In the present embodiment, a laminate for a solar battery back-sheet is a laminate comprising a vinylidene chloride-based resin layer and a silicone-modified acrylic-based resin layer laminated on the vinylidene chloride-based resin layer.
In the present embodiment, the vinylidene chloride-based resin layer is essential for maintaining a gas barrier property such as a water-vapor barrier property required as the solar battery back-sheet. On the other hand, the silicone-modified acrylic-based resin layer is essential for maintaining appropriate resistance to environment, that is, tolerance to a severe natural environment for a long time, required for the solar battery back-sheet, in particular, weather resistance.
Furthermore, the silicone-modified acrylic-based resin layer is preferably laminated on the vinylidene chloride-based resin layer in direct contact therewith in order to exhibit weather resistance and humidity resistance to the maximum. By virtue of the structure, even if a single gas barrier layer is used, the gas-barrier property required for the solar battery back-sheet can be sufficiently expressed.

In the present embodiment, another layer may be interposed between the vinylidene chloride-based resin layer and the silicone-modified acrylic-based resin layer. Also in this case, properties such as water-vapor barrier property, weather resistance, humidity resistance and heat resistance required for the solar battery back-sheet are exhibited.
Furthermore, in the present embodiment, it is preferred that the silicone-modified acrylic-based emulsion is directly applied onto the vinylidene chloride-based resin layer to thereby laminate these two layers consecutively on a plastic base material (more specifically, the vinylidene chloride-based resin layer and the silicone-modified acrylic-based resin layer are laminated in direct contact with each other).
It is more preferred that the vinylidene chloride-based resin layer is laminated on a plastic base material and the silicone-modified acrylic-based resin layer is further laminated thereon in direct contact with it in view of various properties of the laminate for the solar battery back-sheet, such as weather resistance, heat resistance, humidity resistance, gas-barrier property, electrical insulation property and physical strength.

### (Vinylidene chloride-based resin layer)

In the present embodiment, the vinylidene chloride-based resin layer is not particularly limited as long as it is formed of e.g., a vinylidene chloride-based film, a vinylidene chloride resin and a vinylidene chloride emulsion; however, preferably produced from a vinylidene chloride emulsion or a vinylidene chloride lacquer, which is prepared by dissolving a vinylidene chloride resin in a solvent, and more preferably produced from a vinylidene chloride emulsion since the film thickness is easily controlled.
Furthermore, in view of productivity such as simplification of a member structure and processability, it is more preferred that the vinylidene chloride-based resin layer is obtained by coating a vinylidene chloride emulsion or a vinylidene chloride lacquer.
Note that the vinylidene chloride-based resin layer refers to a layer formed of a vinylidene chloride-based resin alone or a resin composition containing this. Furthermore, the vinylidene chloride-based resin is a polymer containing vinylidene chloride as a monomer component, more specifically, may be a homopolymer of vinylidene chloride or a copolymer of vinylidene chloride and another monomer copolymerizable with this. In the case of a copolymer of the vinylidene chloride-based resin, a ratio of vinylidene chloride in the vinylidene chloride resin is preferably, not less than 50% by mass, more preferably 50 to 94% by mass, further preferably, 80 to 93% by mass, and further more preferably 88 to 92% by mass.
Furthermore, the vinylidene chloride resin refers to a dry powder formed of a vinylidene chloride-based resin alone or a resin composition containing this.
Furthermore, the vinylidene chloride-based film refers to a film formed of a vinylidene chloride-based resin alone or a resin composition containing this.
The vinylidene chloride emulsion is not particularly limited as long as it is an emulsion of a resin composition produced by polymerizing vinylidene chloride as a main component. An emulsion containing another component may be used and may contain a vinylidene chloride copolymer copolymerized with another component. The vinylidene chloride emulsion is preferably obtained by emulsion polymerization of a monomer(s) containing not less than 50% by mass of vinylidene chloride based on the total amount of the monomers. The content of vinylidene chloride is more preferably 50 to 94% by mass, further preferably, 80 to 93% by mass, and further more preferably 88 to 92% by mass based on the total amount of the monomers.
If the ratio of vinylidene chloride is not less than 50% by mass, it is possible to maintain a gas barrier property such as water-vapor barrier property. Furthermore, if the ratio of vinylidene chloride is not more than 94% by mass, the vinylidene chloride-based resin layer excellent in practical film-forming property of a coating film can be obtained.
The vinylidene chloride lacquer is not particularly limited as long as it is obtained by dissolving the vinylidene chloride-based resin powder, for example, a powder obtained by aggregating, washing and drying the aforementioned emulsion, in an organic solvent. As the organic solvent, any organic solvent is used as long as it can dissolve the vinylidene chloride resin and be vaporized during a drying process. Examples thereof include ethyl acetate, butyl acetate, toluene, methylethylketone and tetrahydrofuran. They can be used singly or as a mixture containing two types or more in an arbitrary ratio.

In the present embodiment, specific examples of the monomer copolymerizable with vinylidene chloride include vinyl chloride, an acrylic acid ester such as methyl acrylate, ethyl acrylate, butyl acrylate, 2-ethylhexyl acrylate and 2-hydroxyethyl acrylate, a methacrylic acid ester such as methyl methacrylate and glycidyl methacrylate, acrylonitrile, methacrylonitrile, and an unsaturated carboxylic acid such as acrylic acid, methacrylic acid, itaconic acid and maleic acid.
Of these monomers, a single monomer or two or more monomers can be selected and put in use.

Furthermore, to the vinylidene chloride emulsion and the vinylidene chloride lacquer, various types of additives such as an inorganic slipping agent (for example, silica particle) and an organic slipping agent for preventing blocking of a film, a crystal nucleus for accelerating crystallization, and an adhesive, may be added.
The addition amounts of the additives are preferably as follows: the amount of the inorganic slipping agent is preferably 0.2 to 0.5% by mass relative to the amount of the vinylidene chloride-based resin, the amount of the organic slipping agent is preferably 0.2 to 2.0% by mass, and the amount of the adhesive is preferably 1 to 6% by mass.
As the adhesive herein, any adhesive may be used as long as it can be homogeneously dissolved or dispersed in the vinylidene chloride emulsion and the vinylidene chloride lacquer. Examples thereof include a urethane-based adhesive and an epoxy-based adhesive.

As a method for coating the vinylidene chloride emulsion or the vinylidene chloride lacquer, it is preferred to employ a method for coating the vinylidene chloride emulsion onto a base material and drying it to form a vinylidene chloride-based film. A concentration of a coating solution herein is preferably 1 to 70% by mass. The drying process is preferably performed at a temperature of 20 to 150°C.
To allow the vinylidene chloride-based resin layer obtained by coating to deliver sufficient performance, the layer coated is preferably allowed to stand still for aging to accelerate crystallinity. For this purpose, the aging process is preferably performed at 20 to 90°C.
Examples of the coating method of the vinylidene chloride emulsion or the vinylidene chloride lacquer include various methods such as gravure coating, dipnip coating, metering bar coating and air-knife coating. To allow the vinylidene chloride-based resin layer to deliver a sufficient performance and for uniform coating, the coating is preferably performed by metering bar-coating or air-knife coating.

In the present embodiment, to increase adhesion force between the vinylidene chloride-based resin layer and the base material, corona discharge may be applied to the base material before the coating of the vinylidene chloride emulsion or the vinylidene chloride lacquer. Alternatively, the vinylidene chloride-based resin layer may be laminated via an adhesive.
As the adhesive, any adhesive may be used as long as it can join the base material to be used and the vinylidene chloride-based resin layer. When a plastic material is used as the base material, examples of the adhesive include an epoxy resin-based adhesive, a urethane resin-based adhesive, an acrylic resin-based adhesive, a silicone-modified acrylic resin-based adhesive, vinyl acetate-based adhesive, a styrenebutadiene copolymer-based adhesive and the like. Of these, a urethane resin-based adhesive, an acrylic resin-based adhesive, a silicone-modified acrylic resin-based adhesive and vinyl acetate-based adhesive are preferred.
The adhesive is preferably used, when the vinylidene chloride-based resin layer is formed from the vinylidene chloride lacquer, by a method of adding to the lacquer. At this time, the addition amount thereof is preferably about 1 to 6% by mass relative to the amount of the vinylidene chloride-based resin.
On the other hand, when the vinylidene chloride-based resin layer is formed from the vinylidene chloride emulsion, it is preferred that the adhesive is previously applied onto the base material and the vinylidene chloride emulsion is applied onto the adhesive.

In the present embodiment, a thickness of the vinylidene chloride-based resin layer is preferably 5 to 50 µm, more preferably 5 to 30 µm and further more preferably 10 to 30 µm. The gas-barrier property of the vinylidene chloride-based resin layer obtained by coating the vinylidene chloride emulsion or the vinylidene chloride lacquer onto the plastic base material or the like generally varies depending upon the thickness of the vinylidene chloride-based resin layer. The larger the thickness of the coating film becomes, the higher the gas-barrier property is exhibited.
However, when a large amount of the vinylidene chloride emulsion or the vinylidene chloride lacquer is applied at a time in order to increase the thickness of the coating film of the vinylidene chloride-based resin layer, crack and twist may sometimes be generated in the coating film during a drying process. If such defects are generated in the appearance of the coating film, not only a product is damaged in appearance but also a desired gas-barrier property cannot be exhibited. The coating-film thickness of the vinylidene chloride-based resin layer can be increased, for example, by a method of applying the vinylidene chloride emulsion or the vinylidene chloride lacquer onto a resin layer once coated repeatedly a plurality of times.

### (Silicone-modified acrylic-based resin layer)

In the present embodiment, the silicone-modified acrylic-based resin layer is not particularly limited as long as it is produced from a silicone-modified acrylic-based film, a silicone-modified acrylic resin, a silicone-modified acrylic emulsion or the like. However, the silicone-modified acrylic-based resin layer is preferably produced from the silicone-modified acrylic emulsion in view of convenience in film thickness control.
Furthermore, in view of productivity such as simplification of a member structure and processability, obtaining the silicone-modified acrylic-based resin layer by coating the silicone-modified acrylic emulsion is more preferable.
Note that the silicone-modified acrylic-based resin layer herein refers to a layer formed of a silicone-modified acrylic-based resin alone or a resin composition containing this. Furthermore, the silicone-modified acrylic-based resin refers to a resin or a resin composition in which a siloxane bond and an acrylic-based resin are copresent. For example, the silicone-modified acrylic-based resin may be a copolymer of a silicone modifier (a siloxane compound) and an ethylenically unsaturated monomer, an acrylic resin having a part to which a silicone modifier is bonded, or a mixture of a silicone resin and an acrylic-based resin.
Furthermore, the acrylic-based resin is a polymer containing an ethylenically unsaturated monomer having at least one type of carboxyl group as a monomer component or a homopolymer of an ethylenically unsaturated monomer having at least one type of carboxyl group or a copolymer of an ethylenically unsaturated monomer having at least one type of carboxyl group and another monomer copolymerizable with this. In the case of the copolymer, a ratio of the polymerized ethylenically unsaturated monomer having at least one type of carboxyl group may be not less than 50% by mass, 50 to 94% by mass, 80 to 93% by mass, or 88 to 92% by mass. Examples of the ethylenically unsaturated monomer include a methacrylic acid monomer, an acrylic acid monomer, a methacrylate monomer and an acrylate monomer.
The silicone resin refers to a polymer compound having a siloxane bond.
Furthermore, the silicone-modified acrylic-based film and the silicone-modified acrylic resin refer to a film and dry powder formed of a silicone-modified acrylic-based resin alone or a resin composition containing this, respectively.
Furthermore, the silicone-modified acrylic-based resin layer may be obtained by coating a paint in which the silicone-modified acrylic emulsion is blended with a pigment. The pigment is not particularly limited. For example, as a white pigment, an inorganic pigment such as zinc oxide, white lead, calcium carbonate, lithopone (a mixture of zinc sulfide and barium sulfate), titanium dioxide, sedimentary barium sulfate and baryte powder, and an organic pigment such as a polystyrene-based copolymer particle can be used. Furthermore, a black pigment such as carbon black, a red pigment such as red lead and iron oxide red, a yellow pigment such as chrome yellow and zinc yellow and a blue pigment such as ultramarine blue, Prussia blue (iron/potassium ferrocyanide) can be used. In view of increasing a conversion rate to electricity by reflecting incident light upon a solar battery module, the white pigment is preferably used. Of them, titanium dioxide, zinc oxide and calcium carbonate are more preferably used.
In the paint formed of the pigment and the silicone-modified acrylic emulsion, if necessary a dispersant, a pH adjuster, a defoaming agent, a thickening agent and a film-forming auxiliary (an organic solvent), etc., are used. The film-forming auxiliary that can be used will be described later.
A blending ratio of the pigment and the silicone-modified acrylic emulsion is preferably 20 to 60% by mass (pigment) and 40 to 80% by mass (silicone-modified acrylic resin) in terms of mass ratio in a dried coating film, more preferably 30 to 50% by mass (pigment) and 50 to 70% by mass (silicone-modified acrylic resin).
If the mass ratio of the pigment is not less than 20% by mass, the opacity of a coating film increases. In the case of the white pigment, incident light upon a photovoltaic power generation cell can be efficiently reflected. On the other hand, if the mass ratio is not more than 60% by mass, the film formation property of the coating film and the weather resistance under a natural environment become satisfactory.

In the present embodiment, as the silicone-modified acrylic emulsion, in view of weather resistance, a silicone-containing polymer emulsion is preferable, which is obtained by polymerizing a silicone modifier, an ethylenically unsaturated monomer having at least one type of carboxyl group (hereinafter, sometimes simply referred to as an "ethylenically unsaturated monomer A"), another ethylenically unsaturated monomer (hereinafter, sometimes simply referred to as "ethylenically unsaturated monomer B"), which is different from the ethylenically unsaturated monomer having at least one type of carboxyl group and an emulsifier. To the silicone-modified acrylic emulsion, in view of light resistance, a UV ray absorbent and/or a photostabilizer are preferably added. Furthermore, in the silicone-modified acrylic emulsion, a UV ray absorbent and/or a photostabilizer may be copolymerized.

In the present embodiment, examples of a method of producing the silicone-modified acrylic emulsion by polymerization include polymerization methods such as emulsion polymerization, suspension polymerization, mass polymerization and mini-emulsion polymerization, but not limited to these.
As a method for stably manufacturing an emulsion having an average particle size of about 10 nm to 1 µm excellent in dispersion stability, emulsion polymerization is preferable.

In the present embodiment, with respect to emulsion polymerization, emulsion polymerization based on radical polymerization between radically polymerizable monomers, namely, ethylenically unsaturated monomer A, and ethylenically unsaturated monomer B and emulsion polymerization based on a hydrolysis/condensation reaction of a silicone modifier are preferably performed simultaneously in an aqueous medium. In this manner, a silicone-modified acrylic emulsion containing an acrylic resin and a silicone resin can be obtained.
As the aqueous medium, water is mainly used. Also a medium prepared by adding a water-soluble solvent such as a lower alcohol having 1 to 3 carbon atoms or acetone to water can be used. At this time, the amount of solvent to be added other than water is preferably not more than 20% by mass in a pre-emulsified liquid before initiation of polymerization. If the amount of solvent other than water is not more than 20% by mass, the emulsion state of the pre-emulsified liquid is not destroyed and emulsion polymerization stably proceeds. Further preferably, emulsion polymerization is performed by using water alone as a solvent.

In the present embodiment, the pH of the pre-emulsified liquid containing at least one type of ethylenically unsaturated monomer A, at least one type of ethylenically unsaturated monomer B and the emulsifier before subjected to emulsion polymerization, is not particularly limited; however, it is preferably not more than pH 4.0. If emulsion polymerization is carried out at not more than pH 4.0, the condensation reaction of the silicone modifier smoothly occurs, suppressing a condensation reaction from proceeding after the emulsion polymerization. In view of storage stability of a product, the pH of the reaction system is preferably 4.0 or less, and more preferably, not less than pH 1.5 to not more than 3.0.
Furthermore, in the present embodiment, a method of introducing a radical initiator in performing emulsion polymerization is not particular limited. A persulfate or the like serving as the radical initiator may be previously introduced into a reaction system. Furthermore, a pre-emulsified liquid containing at least one type of ethylenically unsaturated monomer A, at least one type of ethylenically unsaturated monomer B, the emulsifier and the radical initiator can be successively added directly to the reaction system. Furthermore, separately from the pre-emulsified liquid, an aqueous solution system thereof or the like can be successively introduced into the reaction system.

In the radical polymerization, the silicone modifier may be added before emulsion polymerization, during emulsion polymerization or after emulsion polymerization. More preferably, the silicone modifier is added during emulsion polymerization. Furthermore, in the emulsion polymerization, emulsion polymerization based on a hydrolysis/condensation reaction of the silicone modifier is particularly preferably initiated simultaneously with initiation of emulsion polymerization based on the radical polymerization of ethylenically unsaturated monomer A and ethylenically unsaturated monomer B.
Furthermore, a silicone resin obtained by hydrolysis/condensation reaction of the silicone modifier may be blended with an acrylic emulsion containing an acrylic resin.

In the present embodiment, the silicone modifier used herein contains at least one of the silane compound (1), silane compound (2) and silane compound (3) represented by the following formula (1), (2) and (3), respectively, and a cyclic silane compound. Two or more compounds of these may be used in combination.
To maintain weather resistance required for the solar battery back-sheet, the silane compound (2) is preferably used in combination with the silane compound (3).

R¹R²ₘSiR³₍₃₋ₘ₎ (1)

(in the formula,
R¹ represents a phenyl group or a cyclohexyl group,
R² represents a hydrogen atom, an aliphatic hydrocarbon group having 1 to 16 carbon atoms, an aryl group having 6 to 10 carbon atoms, a cycloalkyl group having 5 to 6 carbon atoms, an alkyl acrylate group having 1 to 10 carbon atoms or an alkyl methacrylate group having 1 to 10 carbon atoms,
R³s are each independently selected from an alkoxy group having 1 to 8 carbon atoms, an acetoxy group or a hydroxy group, and
m is 0 or 1)

CH₃Si(R⁴)₃ (2)

(in the formula,
R⁴s are each independently selected from an alkoxy group having 1 to 8 carbon atoms, an acetoxy group or a hydroxy group)

(CH₃)₂Si(R⁵)₂ (3)

(in the formula,
R⁵s are each independently selected from an alkoxy group having 1 to 8 carbon atoms, an acetoxy group or a hydroxy group).

In the present embodiment, it is preferred that at least one type of silane compound (1) is contained as a silicone modifier. This is because, after polymerization, the silicone resin and the acrylic resin are smoothly copresent.
Furthermore, it is preferred that at least one type of silane compound (2) is contained as a silicone modifier. This is because a crosslink density of a silicone structure is increased.
Furthermore, it is preferred that at least one type of silane compound (3) and/or a cyclic silane compound is contained as a silicone modifier because the crosslink density of the silicone polymer formed by the silicone modifier is reduced, thereby imparting flexibility when the silicone-modified acrylic emulsion is coated.

In the present embodiment, specific examples of the silane compound (1) used herein include phenyltrimethoxysilane, diphenyldimethoxysilane, phenyltriethoxysilane, diphenyldiethoxysilane, phenylmethyldimethoxysilane, cyclohexyltrimethoxysilane, dicyclohexyldimethoxysilane, cyclohexyltriethoxysilane and dicyclohexyldiethoxysilane. These compounds may be used alone and two types or more of these may be used.
As the silane compound (1), phenyltrimethoxysilane is preferable.

In the present embodiment, specific examples of the silane compound (2) used herein include methyltrimethoxysilane and methyltriethoxysilane. These compounds may be used alone and two types or more of these may be used.
As the silane compound (2), methyltrimethoxysilane is preferable.

In the present embodiment, specific examples of the silane compound (3) used herein include dimethyldimethoxysilane and dimethyldiethoxysilane. These compounds may be used alone and two types or more of these may be used.
As the silane compound (3), dimethyldimethoxysilane is preferable.

In the present embodiment, specific examples of the cyclic silane compound used herein include octamethylcyclotetrasiloxane, octaphenylcyclotetrasiloxane, hexamethylcyclotrisiloxane, decamethylcyclopentasiloxane and tetramethyltetravinylcyclotetra siloxane. These compounds may be used alone and two types or more of these may be used.

Examples of the silicone modifier, can include, in addition to the silicone modifiers selected from the silane compound (1), silane compound (2), silane compound (3) and cyclic silane compound, isobutyltrimethoxysilane, vinyltriethoxysilane, γ-acryloxypropyltrimethoxysilane, γ-acryloxypropyltriethoxysilane, γ-methacryloxypropyltrimethoxysilane, γ-methacryloxypropyltriethoxysilane, γ-methacryloxypropylmethyldimethoxysilane, γ-glycidoxypropyldimethoxymethylsilane, γ-glycidoxypropyltriethoxysilane, tetramethoxysilane and tetraethoxysilane.

Furthermore, an emulsion may be prepared from ethylenically unsaturated monomer A, ethylenically unsaturated monomer B and the emulsifier with or without addition of the silicone modifier and a silicone emulsion may be blended later. Examples of the silicone emulsion to be blended later include, other than a dimethylsilicone emulsion, a phenyl-based, linear alkyl-based, hydrogen-based, amino-based, epoxy-based, and mercapto-based silicone emulsions and a silicone resin emulsion.

In the silicone-modified acrylic-based resin layer according to the present embodiment, since the silicone modifier is hydrolyzed and condensated, the silicone resin (a siloxane bond) is present within the acrylic-based resin (acrylic emulsion particle), extremely excellent weather resistance can be attained.
Furthermore, the presence of the silicone modifier condensate can be confirmed by ²⁹Si-NMR (²⁹Si nuclear magnetic resonance spectrum) or ¹H-NMR (proton nuclear magnetic resonance spectrum). Note that, ¹H-NMR (proton nuclear magnetic resonance spectrum) employs tetramethylsilane as the internal standard; however, ²⁹Si-NMR (²⁹Si nuclear magnetic resonance spectrum) does not employ the internal standard. In this case, silicon rubber is measured and its signal is regarded as - 22 ppm. Alternatively, a measurement value of a solution sample having tetramethylsilane dissolved in chloroform is regarded as 0 ppm, and used as the external standard.
For example, the condensate of the silane compound (1) can be identified by a peak of ²⁹Si-NMR chemical shift emerging at - 35 to - 90 ppm. Furthermore, the condensate of the silane compound (2) can be identified by a peak of ²⁹Si-NMR chemical shift emerging at - 40 to - 80 ppm. Moreover, the condensate of the silane compound (3) can be identified by a peak of ²⁹Si-NMR chemical shift emerging at - 16 to - 26 ppm. Furthermore, the condensate of the cyclic silane compound can be identified by a peak of ²⁹Si-NMR chemical shift emerging in accordance with its structure.

In the present embodiment, the silicone modifier is used preferably in an amount of 0.1 to 200% by mass, more preferably, 0.1 to 120% by mass, further preferably, 0.1 to 80% by mass, and further more preferably, 1 to 10% by mass based on the total mass of ethylenically unsaturated monomer A and ethylenically unsaturated monomer B.

In the present embodiment, examples of ethylenically unsaturated monomer A used herein include a radically polymerizable carboxylic acid monomer having at least one type of carboxyl group and copolymerizable with ethylenically unsaturated monomer B. Specific examples thereof include, acrylic acid, methacrylic acid, itaconic acid and mono esters thereof, fumaric acid and a mono ester thereof and maleic acid and a mono ester thereof (hereinafter, acrylic acid and methacrylic acid will be sometimes collectively referred simply to as (meth)acrylic acid).
Ethylenically unsaturated monomer A is also used as a catalyst for accelerating a hydrolysis reaction and condensation reaction of the silicone modifier and therefore preferably contains at least one selected from these groups.
In the present embodiment, ethylenically unsaturated monomer A is used in an amount of preferably, 0.1 to 15% by mass based on the total mass of ethylenically unsaturated monomer A and ethylenically unsaturated monomer B.

In the present embodiment, examples of ethylenically unsaturated monomer B used herein, which is at least one type of comonomer copolymerizable with ethylenically unsaturated monomer A, include a (meth)acrylate monomer represented by a (meth)acrylic acid ester and a (meth)acrylamide monomer and other vinyl monomers.
Specific examples of the (meth)acrylate monomer include a alkyl (meth)acrylate having an alkyl moiety with 1 to 18 carbon atoms, (poly)oxyethylene mono(meth)acrylate having 1 to 100 ethylene oxide units, (poly)oxypropylene mono(meth)acrylate, a hydroxy alkyl (meth)acrylate having an alkyl moiety with 1 to 18 carbon atoms and (poly)oxyethylene di(meth)acrylate having 1 to 100 ethylene oxide units.

Specific examples of the alkyl (meth)acrylate include methyl (meth)acrylate, ethyl (meth)acrylate, n-butyl (meth)acrylate, isobutyl (meth)acrylate, t-butyl (meth)acrylate, 2-ethylhexyl (meth)acrylate, dodecyl (meth)acrylate and cycloalkyl (meth)acrylate.
As the alkyl (meth)acrylate, methyl methacrylate, n-butyl methacrylate, butyl acrylate, 2-ethylhexyl methacrylate, cyclohexyl (meth)acrylate, 2-hydroxycyclohexyl (meth)acrylate, methylcyclohexyl (meth)acrylate and 2,3-cyclohexeneoxide (meth)acrylate are preferable.

Specific examples of the (poly)oxyethylene mono(meth)acrylate include ethylene glycol (meth)acrylate, ethylene glycol methoxy(meth)acrylate, diethylene glycol (meth)acrylate, diethylene glycol methoxy(meth)acrylate, tetraethylene glycol (meth)acrylate and tetraethylene glycol methoxy(meth)acrylate.

Specific examples of the (poly)oxypropylene mono(meth)acrylate include propylene glycol (meth)acrylate, propylene glycol methoxy(meth)acrylate, dipropylene glycol (meth)acrylate, dipropylene glycol methoxy(meth)acrylate, tetrapropylene glycol (meth)acrylate and tetrapropylene glycol methoxy(meth)acrylate.

Specific examples of the hydroxy alkyl (meth)acrylate include 2-hydroxyethyl (meth)acrylate and 2-hydroxypropyl (meth)acrylate.

Specific examples of the (poly)oxyethylene di(meth)acrylate include ethylene glycol di(meth)acrylate, diethylene glycol di(meth)acrylate, triethylene glycol di(meth)acrylate and tetra ethylene glycol di(meth)acrylate.

Examples of ethylenically unsaturated monomer B include, other than those mentioned above, glycidyl (meth)acrylate and trimethylolpropane tri(meth)acrylate.

A content of the (meth)acrylate monomer is preferably, 80 to 100% by mass based on the total mass of ethylenically unsaturated monomer B, and more preferably, 90% by mass to 100% by mass.

In the present embodiment, of the (meth)acrylate monomers serving as a main component of ethylenically unsaturated monomer B, a (meth)acrylate monomer having a cycloalkyl group is preferable. If the (meth)acrylate monomer having a cycloalkyl group is further contained, the silicone-modified acrylic-based resin layer excellent in tolerance can be obtained.
A part of hydrogen atoms of the cycloalkyl group may be substituted with an alkyl group having 1 to 6 carbon atoms and a hydroxy group, and furthermore, epoxy groups may be circularly present.

As the (meth)acrylate monomer having a cycloalkyl group, cycloalkyl (meth)acrylate is mentioned. Examples of the cycloalkyl (meth)acrylate include an ester of a cycloalkyl group having 5 to 12 carbon atoms.
Specific examples of the (meth)acrylate monomer having a cycloalkyl group include a compound represented by the following formula (4).

CH₂ = C(R⁶)COOR⁷ (4)

(in the formula,
R⁶ represents a hydrogen atom or a methyl group,
R⁷ represents a cyclopentyl group, a cyclohexyl group or a cyclododecyl group, and these cycloalkyl groups may have an alkyl group having 1 to 6 carbon atoms, a hydroxy group or an epoxy group as a substituent).

Specific examples of the compound represented by the formula (4) include cyclohexyl (meth)acrylate, 2-hydroxycyclohexyl (meth)acrylate, methylcyclohexyl (meth)acrylate and 2,3-cyclohexene oxide (meth)acrylate.
Of them, cyclohexyl methacrylate is preferable.

Of (meth)acrylate monomers serving as the main component of ethylenically unsaturated monomer B, a ratio of a (meth)acrylate monomer having a cycloalkyl group is preferably not less than 5% by mass based on the total mass of (meth)acrylate monomer in ethylenically unsaturated monomer B, more preferably 5% by mass to 99% by mass and further preferably 5% by mass to 80% by mass.
The (meth)acrylate monomer having the cycloalkyl group may be used singly or as a mixture of two or more types.
If the (meth)acrylate monomer having the cycloalkyl group is contained in an amount of not less than 5% by mass based on the total mass of the (meth)acrylate monomer in the ethylenically unsaturated monomer B, the silicone-modified acrylic-based resin layer excellent in tolerance can be obtained. If the content is not more than 99% by mass, the film-forming property of the silicone-modified acrylic emulsion becomes excellent.

Examples of the (meth)acrylamide monomer include (meth)acrylamide, diacetone(meth)acrylamide, N-methylol(meth)acrylamide and N-butoxymethyl(meth)acrylamide.
Examples of other vinyl monomers include vinyl acetate, vinyl propionate, vinyl versatate, vinyl pyrrolidone and methylvinyl ketone.
Furthermore, examples of other vinyl monomers include vinyl cyan monomer such as acrylonitrile and methacrylonitrile.
Moreover, examples of other vinyl monomers also include an aromatic monomer such as vinyl toluene, styrene and α-methylstyrene and a vinyl halide such as vinyl chloride and vinylidene chloride, butadiene and ethylene.

In the present embodiment, ethylenically unsaturated monomer B is preferably used in an amount of 85 to 99.9% by mass based on the total mass of eethylenically unsaturated monomer A and ethylenically unsaturated monomer B.

In the present embodiment, the emulsifier used herein preferably contains at least either one of the ethylenically unsaturated monomer having a sulfonic acid group (-SO₃H) or a sulfonate group (-SO₃M) and an ethylenically unsaturated monomer having a sulfate group (-OSO₃H or -OSO₃M) in order to obtain a silicone-modified acrylic-based resin layer having high water resistance.

In the present embodiment, examples of the ethylenically unsaturated monomer having the sulfonic acid group or the sulfonate group include a compound having a radically polymerizable double bond and a free sulfonic acid group, or a group, which is an ammonium salt or alkali metal salt of sulfonic acid (ammonium sulfonate group or alkali metal sulfonate group).
A compound having substituent selected from the group consisting of an alkyl group having 1 to 20 carbon atoms, an alkyl ether group having 2 to 4 carbon atoms, a polyalkyl ether group having 2 to 4 carbon atoms, an aryl group having 6 or 10 carbon atom and a succinic acid group, partly substituted with a group, which is an ammonium salt, sodium salt or potassium salt of a sulfonic acid group, or a vinyl sulfonate compound having a vinyl group bound to a group, which is the ammonium salt, the sodium salt or the potassium salt of the sulfonic acid group is preferable

In the present embodiment, specific examples of the succinic acid compound partly substituted with the group, which is the ammonium salt, sodium salt or potassium salt of the sulfonic acid group, include allylsulfo succinate compounds, for example, represented by the following formulas (5) to (8).

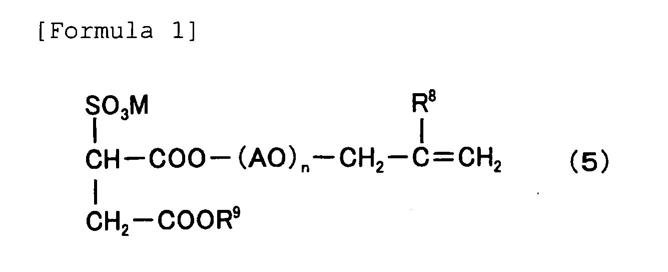

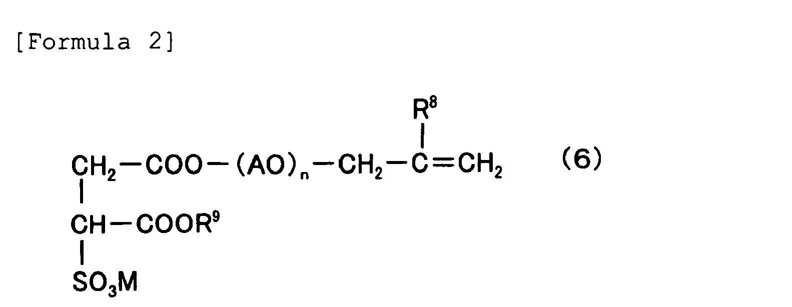

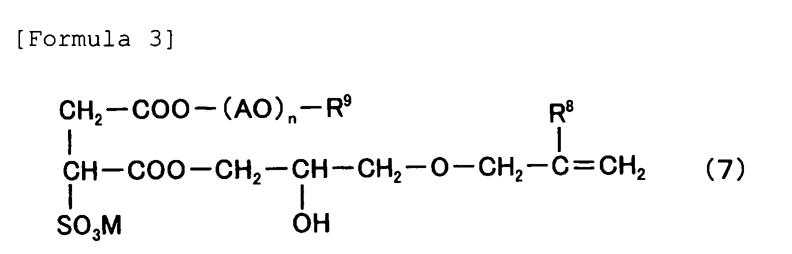

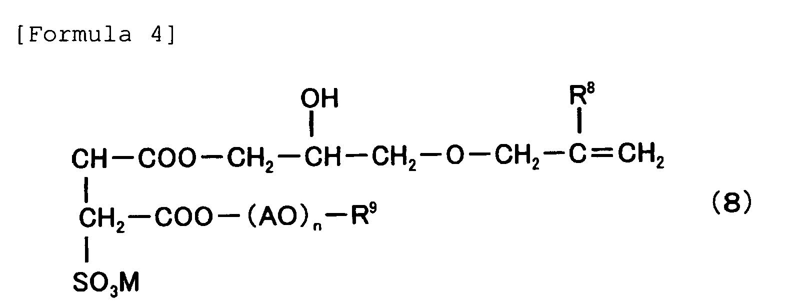

(in the formulas (5) to (8),
R⁸ represents a hydrogen atom or a methyl group,
R⁹ represents a hydrocarbon group, which is an alkyl group having 1 to 20 carbon atoms, an alkenyl group having 1 to 20 carbon atoms, a cycloalkyl group having 5 to 12 carbon atoms, an aralkyl group having 7 to 19 carbon atoms or a hydrocarbon group partly substituted with a hydroxy group, a carboxylic acid group or a polyoxyalkylene alkyl ether group (the number of carbon atoms of the alkyl moiety is 1 to 20 and the number of carbon atoms of the alkylene moiety is 2 to 4) or a polyoxyalkylene alkyl phenyl ether group (the number of carbon atoms of the alkyl moiety is 1 to 20 and the number of carbon atoms of the alkylene moiety is 2 to 4),
A represents an alkylene group having 2 to 4 carbon atoms or an alkylene group having hydrogen atoms partly substituted with a hydroxy group or a carboxylic acid group,
M represents ammonium, sodium or potassium, and
n is an integer of 0 to 200).

Examples of the emulsifiers containing compounds represented by the formulas (5) and (6) include ELEMINOL JS-2, JS-5(registered trade mark, manufactured by Sanyo Chemical Industries, Ltd.). Examples of the emulsifiers containing the formulas (7) and (8) include LATEMUL S-120, S-180A, S-180 (registered trade mark, manufactured by Kao Corp.).

Furthermore, specific examples of the compound having the aryl group partly substituted with the sulfonate group include ammonium, sodium and potassium p-styrenesulfonates. Specific examples of the compound having the alkyl group partly substituted with the sulfonate group include an ammonium salt and sodium salt and potassium salt of methyl propane sulfonate acrylamide, an ammonium salt, sodium salt and potassium salt of a sulfoalkyl acrylate, and an ammonium salt, sodium salt and potassium salt of a sulfoalkyl (meth)acrylate.

In the present embodiment, the ethylenically unsaturated monomer having the sulfate group refers to a compound having a radically polymerizable double bond and having a group, which is a sulfate group, an ammonium salt or an alkali metal salt thereof. Of these, a compound having a group selected from the group consisting of an alkyl group having 1 to 20 carbon atoms, an alkyl ether group having 2 to 4 carbon atoms, a polyalkyl ether group having 2 to 4 carbon atoms and an aryl group having 6 or 10 carbon atoms, partly substituted with a group, which is an ammonium salt, sodium salt or potassium salt of a sulfate group is preferable.

In the present embodiment, specific examples of the compound having the alkyl ether group having 2 to 4 carbon atoms or a polyalkyl ether group having 2 to 4 carbon atoms, partly substituted with the ammonium salt, sodium salt or potassium salt of the sulfate group include compounds represented by the following formulas (9) to (11). 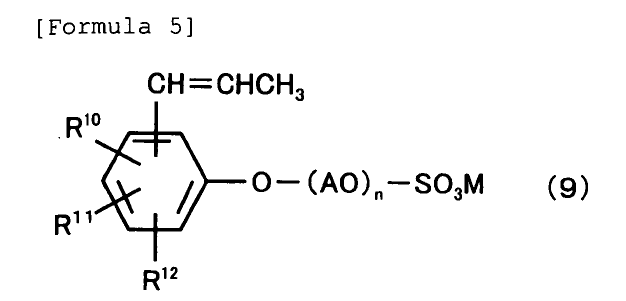 (in the formula,
R¹⁰ represents an alkyl group, an alkenyl group or an aralkyl group having 6 to 18 carbon atoms,
R¹¹ represents an alkyl group, alkenyl group or aralkyl group having 6 to 18 carbon atoms,
R¹² represents a hydrogen atom or a propenyl group,
A represents an alkylene group having 2 to 4 carbon atoms,
M represents ammonium, sodium, potassium or alkanol amine residue, and
n is an integer of 1 to 200). 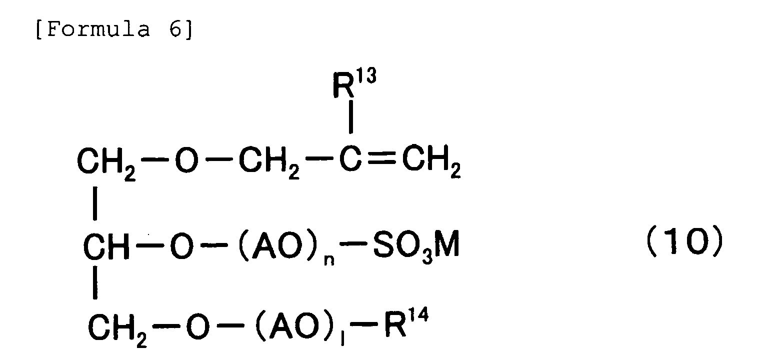 (in the formula,
R¹³ represents a hydrogen atom or a methyl group,
R¹⁹ represents an alkyl group, alkylphenyl group or acyl group having 8 to 24 carbon atoms,
A represents an alkylene group having 2 to 4 carbon atoms,
M represents ammonium, sodium, potassium or alkanol amine residue,
1 is an integer of 0 to 50, and
n is an integer of 0 to 20). 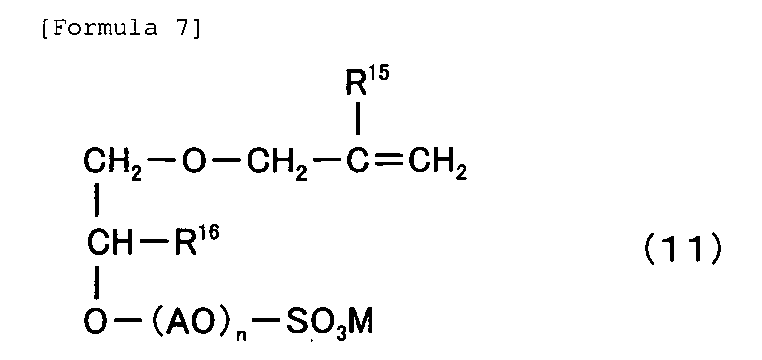 (in the formula,
R¹⁵ represents a hydrogen or a methyl group,
R¹⁶ represents an alkyl group having 8 to 30 carbon atoms,
A represents an alkylene group having 2 to 4 carbon atoms or an substituted alkylene group having hydrogen atoms partly substituted with a hydroxy group or a carboxylic acid group,
M represents ammonium, sodium, potassium or alkanol amine residue, and
n is an integer of 0 to 200).

Examples of the compound represented by the formula (9) include AQUARON HS-10 (registered trade mark, manufactured by Dai-ichi Kogyo Seiyaku Co., Ltd.). Examples of the compound represented by the formula (10) include ADEKA REASOAPs SE-1025A, SR-10N and SR-20N (product name, manufactured by ADEKA Corp.). Examples of the compound represented by the formula (11) include AQUARON KH-10 and KH-05 (registered trade mark, manufactured by Dai-ichi Kogyo Seiyaku Co., Ltd.).

In the present embodiment, the ethylenically unsaturated monomer having the sulfonic acid group, the sulfonate group or the sulfate group and used as the emulsifier is present as a copolymer radically polymerized with an emulsion particle in an emulsion, present as an unreacted product, which adsorbs to an emulsion particle or in emulsion water-phase, or present as a copolymer with a water-soluble monomer or a copolymer formed of ethylenically unsaturated monomers serving as the emulsifier and present by adsorbing to an emulsion particle or in an emulsion water phase.
Of them, if a ratio of the ethylenically unsaturated monomer present as the copolymer radically polymerized with the emulsion particle is increased, humidity resistance of a film obtained from the emulsion can be increased.
Each of the ethylenically unsaturated monomers to be used as the emulsifier, can be identified by subjecting the film obtained from the emulsion to pyrolytic gas chromatographic mass spectrometry (Py-GC-MS).

In the present embodiment, the emulsifier is used in an amount of preferably, 0.05% by mass to 10% by mass based on the total mass of ethylenically unsaturated monomer A and ethylenically unsaturated monomer B, and more preferably, 0.1% by mass to 5% by mass.

In the present embodiment, other than the emulsifier containing the ethylenically unsaturated monomer having the sulfonic acid group, the sulfonate group or the sulfate group, a general surfactant can be used in combination. Examples of the surfactant include an anionic surfactant such as a fatty acid soap, an alkyl sulfonate, alkylsulfo succinate, polyoxyethylenealkyl sulfate and polyoxyethylenealkylaryl sulfate; a non-reactive nonionic surfactant such as polyoxyethylene alkylaryl ether, polyoxyethylene sorbitan fatty acid ester and oxyethylene-oxypropylene block copolymer; and a nonionic surfactant copolymerizable with an ethylenically unsaturated monomer, i.e., a so-called a reactive nonionic surfactant, such as α-[1-[(allyloxy)methyl]-2-(nonylphenoxy)ethyl]-ω-hydroxypolyoxyethylene such as ADEKA REASOAPs NE-20, NE-30, NE-40 (product name, manufactured by ADEKA Corp.) or polyoxyethylenealkylpropenylphenyl ether such as AQUARON RN-10, RN-20, RN-30, RN-50 (registered trade mark, manufactured by Dai-ichi Kogyo Seiyaku Co., Ltd.). These may be used in combination.

A use amount of the surfactant is as follows. The use amount of the anionic surfactant is preferably, not more than 0.5% by mass based on the total mass of ethylenically unsaturated monomer A and ethylenically unsaturated monomer B, and more preferably, not more than 0.25% by mass. The use amount of the non-reactive nonionic surfactant and the reactive nonionic surfactant is preferably not more than 2.0% by mass and more preferably, not more than 1.0% by mass. If the surfactant is used within the range, a film having satisfactory humidity resistance can be formed.

In the present embodiment, the silicone-modified acrylic emulsion preferably contains a UV ray absorbent and/or a photostabilizer to obtain a silicone-modified acrylic emulsion having high weather resistance. Furthermore, the silicone-modified acrylic emulsion can be obtained by copolymerizing with the photostabilizer.
A method of adding the UV ray absorbent and/or the photostabilizer to the silicone-modified acrylic emulsion, a film-forming auxiliary and the like are added to the silicone-modified acrylic emulsion and thereafter the UV ray absorbent and/or the photostabilizer may be added; however, in order to exhibit light resistance and tolerance further longer, it is preferred to add the UV ray absorbent and/or the photostabilizer in an emulsion polymerization process. The UV ray absorbent and/or the photostabilizer is used preferably in an amount of 0.1 to 20% by mass based on the total mass of eethylenically unsaturated monomer A and ethylenically unsaturated monomer B, and more preferably 0.1 to 10% by mass. Furthermore, as the UV ray absorbent, a radically polymerized compound having a radically polymerizable double bond within a molecule can be used. Also, as the photostabilizer, a radically polymerized compound having a radically polymerizable double bond within a molecule can be used. Furthermore, when the UV ray absorbent is used in combination with the photostabilizer, a high-tolerance emulsion can be obtained. When a film is formed from the emulsion, a silicone-modified acrylic-based resin layer having the film more excellent in weather resistance can be obtained.

In the present embodiment, as the UV ray absorbent used herein, at least one selected from a benzophenone-based, a benzotriazole-based and a triazine-based compounds is preferable. In the present embodiment, as the photostabilizer used herein, for example, a hindered amine-based compound is preferable. If a silicone-modified acrylic emulsion excellent in tolerance is used in combination with the benzophenone-based, benzotriazole-based, triazine-based UV ray absorbent and/or the photostabilizer having a high UV ray absorptivity, they synergistically work to exhibit excellent tolerance.
Of them, the benzotriazole-based UV ray absorbent and the photostabilizer are more preferably used in combination.

Specific examples of the benzophenone-based UV ray absorbent include 2,4-dihydroxybenzophenone, 2-hydroxy-4-methoxybenzophenone, 2-hydroxy-4-methoxybenzophenone-5-sulfonic acid, 2-hydroxy-4-n-octyloxybenzophenone, 2-hydroxy-4-n-dodecyloxybenzophenone, 2-hydroxy-4-benzyloxybenzophenone, bis(5-benzoyl-4-hydroxy-2-methoxyphenyl)methane, 2,2'-dihydroxy-4-methoxybenzophenone, 2,2'-dihydroxy-4,4'dimethoxybenzophenone, 2,2',4,4'-tetrahydroxybenzophenone, 4-dodecyloxy-2-hydroxybenzophenone, 2-hydroxy-4-methoxy-2'-carboxybenzophenone and 2-hydroxy-4-stearyloxybenzophenone.
Examples of the radically polymerizable benzophenone-based UV ray absorbent include 2-hydroxy-4-acryloyloxybenzophenone, 2-hydroxy-4-methacryloyloxybenzophenone, 2-hydroxy-5-acryloyloxybenzophenone, 2-hydroxy-5-methacryloyloxybenzophenone, 2-hydroxy-4-(2-acryloyloxyethyloxy)benzophenone, 2-hydroxy-4-(2-methacryloyloxyethyloxy)benzophenone, 2-hydroxy-4-(methacryloxy-diethoxy)benzophenone and 2-hydroxy-4-(acryloxy-triethoxy) benzophenone.

Specific examples of the benzotriazole-based UV ray absorbent include 2-(2'-hydroxy-5'-methylphenyl)benzotriazole, 2-(2'-hydroxy-5'-tert-butylphenyl)benzotriazole, 2-(2'-hydroxy-3',5'-di-tert-butylphenyl)benzotriazole, 2-(2'-hydroxy-5'-tert-octylphenyl)benzotriazole, 2-(2'-hydroxy-3',5'-di-tert-octylphenyl) benzotriazole, 2-[2'-hydroxy-3',5'-bis(α, α'-dimethylbenzyl)phenyl]benzotriazole, a condensate between methyl-3-[3'-tert-butyl-5'-(2H-benzotriazol-2-yl)-4'-hydroxyphenyl]propionate and polyethylene glycol (molecular weight: 300) (product name: TINUVIN (registered trade mark) 1130 manufactured by Nihon Ciba-Geigy K.K.), isooctyl-3-[3'-(2H-benzotriazol-2-yl)-5'-tert-butyl-4'-hydroxyphenyl]propionate (product name: TINUVIN (registered trade mark) 384 manufactured by Nihon Ciba-Geigy K.K.), 2-(3'-dodecyl-5'-methyl-2-hydroxyphenyl)benzotriazole (product name: TINUVIN (registered trade mark) 571 manufactured by Nihon Ciba-Geigy K.K.,), 2-(2'-hydroxy-3'-tert-butyl-5'-methylphenyl)-5-chlorobenzotriazole, 2-(2'-hydroxy-3',5'-di-tert-amylphenyl)benzotriazole, 2-(2'-hydroxy-4'-octoxyphenyl)benzotriazole, 2-[2'-hydroxy-3'-(3'',4'',5'',6''-tetrahydrophthalimidemethyl)-5'-methylphenyl]benzotriazole, 2,2-methylenebis[4'-(1'',1'',3'',3''-tetramethylbutyl)-6'-(2H-benzotriazol-2 " -yl)phenol] and 2-(2H-benzotriazol-2'-yl)-4,6-bis(1'-methyl-1'-phenylethyl)phenol (product name: TINUVIN (registered trade mark) 900 manufactured by Nihon Ciba-Geigy K.K.).
Examples of the radically polymerizable benzotriazole-based UV ray absorbent include 2-[2'-hydroxy-5'-(2"-methacryloyloxyethyl)phenyl)))-2H-benzotriazole (product name: RUVA-93 manufactured by Otsuka Chemical Co., Ltd.,), 2-[2'-hydroxy-5'-(2-methacryloyloxyethyl)-3'-tert-butylphenyl)))-2H-benzotriazole, 2-[2'-hydroxy-5'-(3-methacryloyloxypropyl)-3'-tert-butylphenyl)))-5-chloro-2H-benzotriazole and 3-methacryloyl-2-hydroxypropyl-3-[3'-(2"-benzotriazolyl)-4'-hydroxy-5'-tert-butyl]phenyl propionate (product name: CGL-104 manufactured by Nihon Ciba-Geigy K.K.).
As the benzotriazole-based UV ray absorbent, TINUVIN (registered trade mark) 384 is preferable.

Specific examples of the triazine-based UV ray absorbent include TINUVIN 400, TINUVIN 405, TINUVIN 460, TINUVIN 477DW and TINUVIN 479 (registered trade mark, manufactured by Nihon Ciba-Geigy K.K.).
As the triazine-based UV ray absorbent, TINUVIN 400 is preferable.

As the photostabilizer, a stabilizer having a low basicity is preferable and a stabilizer having a base dissociation constant (pKb) of 8 or more is more preferable.
Specific examples thereof include a hindered amine-based compound such as bis(2,2,6,6-tetramethyl-4-piperidyl)succinate, bis(2,2,6,6-tetramethyl-4-piperidyl)sebacate, bis(1,2,2,6,6-pentamethyl-4-piperidyl)2-(3,5-di-tert-butyl-4-hydroxybenzyl)-2-butyl malonate, 1-[2-[3-(3,5-di-tert-butyl-4-hydroxyphenyl)propionyloxy]ethyl]-4-[3-(3,5-di-tert-butyl-4-hydroxyphenyl)propionyloxy]-2,2,6,6-tetramethylpiperidine, a mixture of bis(1,2,2,6,6-pentamethyl-4-piperidyl)sebacate and methyl-1,2,2,6,6-pentamethyl-4-piperidyl-sebacate (product name: TINUVIN (registered trade mark) 292 manufactured by Nihon Ciba-Geigy K.K.) and bis(1-octoxy-2,2,6,6-tetramethyl-4-piperidyl)sebacate, TINUVIN 123 (registered trade mark, manufactured by Nihon Ciba-Geigy K.K.).
Examples of the radically polymerizable photostabilizer include 1,2,2,6,6-pentamethyl-4-piperidylmethacrylate (product name: ADEKA STUB LA82 manufactured by ADEKA Corp.), 1,2,2,6,6-pentamethyl-4-piperidyl acrylate, 2,2,6,6-tetramethyl-4-piperidyl methacrylate (product name: ADEKA STUB LA87 manufactured by ADEKA Corp.), 2,2,6,6-tetramethyl-4-piperidyl acrylate, 1,2,2,6,6-pentamethyl-4-iminopiperidyl methacrylate, 2,2,6,6,-tetramethyl-4-iminopiperidyl methacrylate, 4-cyano-2,2,6,6-tetramethyl-4-piperidyl methacrylate and 4-cyano-1,2,2,6,6-pentamethyl-4-piperidyl methacrylate.
As the photostabilizer, TINUVIN (registered trade mark) 123 is preferable.

In the present embodiment, emulsion polymerization can be performed by radical decomposition using a polymerization initiator and heat or a reducing substance, thereby causing addition polymerization of an ethylenically unsaturated monomer.
As the polymerization initiator for emulsion polymerization, a persulfate, a peroxide, and an azobis compound, etc. having water solubility or oil solubility can be used.
Specific examples thereof include a persulfate such as potassium persulfate, sodium persulfate and ammonium persulfate; a peroxide such as hydrogen peroxide, t-butyl hydroperoxide and t-butyl peroxybenzoate; and an azobis compound such as 2,2-azobisisobutyronitrile, 2,2-azobis(2-diaminopropane) hydrochloride and 2,2-azobis(2,4-dimethylvaleronitrile).
It is preferred to use potassium persulfate, sodium persulfate, ammonium persulfate, which are also effective as a catalyst for accelerating a hydrolysis reaction and condensation reaction of the silicone modifier.
An amount of the polymerization initiator that can be generally used is 0.05% by mass to 1% by mass based on the total mass of ethylenically unsaturated monomer A and ethylenically unsaturated monomer B.

In the present embodiment, the emulsion polymerization reaction is preferably performed under normal pressure at a reaction temperature of 65 to 90°C; however, the reaction can be carried out also under high pressure in accordance with propertiessuch as vapor pressure at a reaction temperature of a monomer and the like.

In the present embodiment, the reaction time for emulsion polymerization is a sum of introduction time and aging (cooking) time after the introduction. The introduction time is generally several minutes when raw materials are added simultaneously to a reaction system. When raw materials are successively introduced to a reaction system, the introduction time varies depending upon the concentration of a polymer finally obtained in an emulsion since raw materials are introduced at an interval during which heat generated by polymerization can be removed. The introduction time is generally 10 minutes or more. The aging (cooking) time after the introduction is preferably at least 10 minutes.
The aging time of 10 minutes or more is sufficient for reacting raw materials. Furthermore, it is sufficient for a silicone modifier hydrolyzed to condense.
To accelerate the rate of polymerization and to wish polymerization performed at a temperature as low as 70°C or less, a reducing agent such as sodium bisulfite, ferrous chloride, ascorbate and Rongalite is preferably used in combination with a radical polymerization catalyst. Furthermore, to control the molecular weight of a polymer in the resultant silicone-modified acrylic emulsion, a chain transfer agent such as dodecyl mercaptan can be optionally added.

In the present embodiment, in the silicone-modified acrylic emulsion, after completion of emulsion polymerization, a hardening catalyst is used in a film-formation process to obtain a silicone-modified acrylic-based resin layer. Examples thereof include a metal salt of an organic acid such as dibutyltin dilaurate, dioctyltin dilaurate, dibutyltin diacetate, tin octylate, tin laurate, iron octylate, lead octylate and tetrabutyl titanate and an amine compound such as n-hexyl amine and 1,8-diazabicyclo[5,4,0]-7-undecene, which can be added to a highly-tolerable emulsion.
When these hardening catalysts are insoluble in water, they are preferably emulsified by use of a surfactant and water and then put in use.
In the present embodiment, to keep dispersion stability of the emulsion for a long time, the pH of the silicone-modified acrylic emulsion is preferably adjusted within the range of 5 to 10 by use of ammonia, sodium hydroxide, potassium hydroxide and an amine such as dimethylamino ethanol.

In the present embodiment, after completion of the emulsion polymerization, to remove a volatile substance such as an unreacted monomer, water and alcohol, etc., by evaporation, concentration may be performed.

In the present embodiment, an average particle size of a dispersoid of the silicone-modified acrylic emulsion is preferably 10 to 1,000 nm.
Furthermore, in the resultant emulsion, a mass ratio of a dispersoid (solid content) and an aqueous medium serving as the dispersion medium is preferably 70/30 or less, and more preferably, 30/70 or more to 65/35 or less.

In the present embodiment, to the silicone-modified acrylic emulsion, a film-forming auxiliary, a thickening agent, a defoaming agent, a pigment, a dispersant, a dye and an antiseptic agent, etc. can be optionally blended.

Specific examples of the film-forming auxiliary include diethylene glycol monobutyl ether, ethylene glycol monobutyl ether, diethylene glycol diethyl ether, diethylene glycol dibutyl ether, ethylene glycol mono2-ethylhexyl ether, 2,2,4-trimethyl-1,3-butanediol isobutyrate, diisopropyl glutarate, propylene glycol n-butyl ether, dipropylene glycol n-butyl ether, tripropylene glycol n-butyl ether, dipropylene glycol methyl ether and tripropylene glycol methyl ether. These film-forming auxiliaries can be blended singly or arbitrarily in combination.

In the present embodiment, as a method of coating the silicone-modified acrylic emulsion, a method of coating the silicone-modified acrylic emulsion and drying is mentioned. A resin film is formed by the method to produce the silicone-modified acrylic-based resin layer.
A concentration of the coating solution used herein is preferably 1 to 70% by mass and the drying is preferably performed between 20 to 150°C. The emulsion is applied by various methods such as gravure coating, wire-bar coating, air-knife coating, die coat, lip-coat and comma coat.

In the present embodiment, a thickness of the silicone-modified acrylic-based resin layer is preferably 10 to 100 µm, more preferably 20 to 90 µm, and further preferably, 30 to 85 µm. If the thickness of the silicone-modified acrylic-based resin layer is 10 µm or more, a solar battery back-sheet excellent in environment resistance such as tolerance and weather resistance can be obtained. Furthermore, if the thickness of the silicone-modified acrylic-based resin layer is 100 µm or less, few cracks generate during the drying process and a silicone-modified acrylic-based resin layer excellent in film-forming property can be obtained. In the drying process, the aforementioned film-forming auxiliary can be used to enhance film-forming property.

### (Solar battery back-sheet)

In the present embodiment, a solar battery back-sheet is a sheet formed by laminating the aforementioned laminate for the solar battery back-sheet on a base material.
The order of the layers to be laminated is not limited. Specifically, the vinylidene chloride-based resin layer is laminated on the base material, further the silicone-modified acrylic-based resin layer is laminated thereon to form the sheet.
In the present embodiment, if the vinylidene chloride-based resin layer and the silicone-modified acrylic-based resin layer are sequentially laminated on a substrate (more specifically, the vinylidene chloride-based resin layer is laminated on the base material, further the silicone-modified acrylic-based resin layer is laminated thereon in direct contact therewith), the vinylidene chloride-based resin layer can be protected to ensure good gas-barrier property.
Furthermore, it is preferred that the vinylidene chloride-based resin layer is laminated on a plastic base material and the silicone-modified acrylic-based resin layer is laminated thereon in view of various properties of the solar battery back-sheet, such as weather resistance, heat resistance, humidity resistance, gas-barrier property, electrical insulation property and physical strength.

### (Base material)

In the present embodiment, the base material is not particularly limited as long as it can support the laminate for the solar battery back-sheet. For example, a plastic base is preferably used.
In the present embodiment, as the plastic base material used herein, a thermoplastic resin film is preferably used. The thermoplastic resin film is preferably a polyester resin film, which is a polycondensate of a dicarboxylic acid derivative and a diol derivative.
As the thermoplastic resin film, a polyester resin such as polyethylene terephthalate, polypropylene terephthalate, polybutylene terephthalate and polyethylene-2,6-naphthalate can be used. More preferably a polyethylene terephthalate-based resin is used, which is a crystalline thermoplastic resin obtained by polymerization of terephthalic acid and a derivative thereof as a dicarboxylic acid component and ethylene glycol as a glycol component, through an esterification reaction. These resins may be homo resins and may be a copolymer or a mixture. A melting point of the polyester preferable used herein is preferably 250°C or more in view of heat resistance and preferably 300°C or less in view of productivity. Furthermore, the thermoplastic resin is preferably a biaxial stretched film formed of a high molecular-weight polymer having a number average molecular weight within 18,500 to 40,000 in order to impart hydrolysis resistance. To obtain hydrolysis resistance, the higher the number average molecular weight, the more preferable; however, in view of polymerizability, melt moldability and biaxial stretchability, the polyester resin having the number average molecular weight within the above range is preferably used.
In the present embodiment, the number average molecular weight can be determined by e.g., gel permeation chromatography (GPC) generally used.

A thickness of the base material preferably falls within the range of 100 to 350 µm, in view of proper nerve strength, processability and electrical insulation property as the base material for the solar battery back-sheet.
Furthermore, to the base material, various types of surface treatments for coating such as corona discharge treatment, air plasma discharge treatment may be applied and a known adhesive such as an ester-based adhesive and a urethane-based adhesive can be used.

Figure 1 shows a sectional view of the solar battery back-sheet comprising the laminate for the solar battery back-sheet of the present embodiment.
The solar battery back-sheet of the present embodiment will be described referring to Figure 1.
As shown in Figure 1, a solar battery back-sheet 1 comprises a laminate for a solar battery back-sheet formed of a vinylidene chloride-based resin layer 4 and a silicone-modified acrylic-based resin layer 5. The back sheet 1 has the following structure. The vinylidene chloride-based resin layer 4 and the silicone-modified acrylic-based resin layer 5 are laminated on a plastic base 2 via an adhesive 3.

Figure 2 shows a sectional view of a solar battery module comprising the solar battery back-sheet of the present embodiment.
The solar battery module of the present embodiment will be described referring to Figure 2.
As shown in Figure 2, a solar battery module 6 comprises the solar battery back-sheet 1. A solar battery element 8 and a filler 9 are sandwiched between a glass layer 7 to which light is applied and the solar battery back-sheet 1. This is an example of the structure of the module.
The direction of the back-sheet to be installed is not particularly limited; however, the back sheet is preferably provided such that the silicone-modified acrylic-based resin layer faces outside, in view of weather resistance and humidity resistance.
In arranging the plastic base layer so as to face outside, the silicone-modified acrylic-based resin layer is preferably provided on the non-laminate surface of the plastic base material. At this time, in order to increase adhesiveness between the surface of the plastic base material and the silicone-modified acrylic resin surface, it is more preferred that a corona discharge treatment or the like is applied to the surface of the plastic base material in order to facilitate adhesion.

The solar battery back-sheet of the present embodiment comprises the laminate for the solar battery back-sheet comprising the vinylidene chloride-based resin layer and the silicone-modified acrylic-based resin layer laminated on the vinylidene chloride-based resin layer. By virtue of the structure, the sheet is tolerable under a severe natural environment for a long time, particularly excellent in environment resistance, such as hydrolysis resistance or weather resistance, and in various properties such as heat resistance, humidity resistance, gas-barrier property, electrical insulation property and physical strength, as well as excellent in productivity such as simplification of a member structure and processability. This effect is particularly significantly exerted when the silicone-modified acrylic-based resin layer is laminated in direct contact with the vinylidene chloride-based resin layer.
Furthermore, if the solar battery module comprises the aforementioned solar battery back-sheet, it is possible to obtain a solar battery module tolerable under a severe natural environment for a long time, particularly excellent in environment resistance, such as hydrolysis resistance or weather resistance, and excellent in various properties such as heat resistance, humidity resistance, gas-barrier property, electrical insulation property and physical strength.

### [Examples]

The embodiment of the present invention will be more specifically described by way of examples below. However, the present embodiment is not limited only to these Examples.
If otherwise not specified, the "parts" means "parts by mass".

### [Reference Examples]

Examples of methods for producing a vinylidene chloride emulsion, a vinylidene chloride lacquer, a silicone-modified acrylic emulsion and an example of a method for producing an acrylic emulsion used as a comparative example will be described as Reference Examples below.

### (Vinylidene chloride emulsion)

### [Reference Example 1]

In a pressure resistant reaction vessel provided with glass lining, ion-exchanged water (100 parts), sodium alkyl sulfate (0.1 part) and sodium persulfate (0.9 parts) were placed. After air was purged, the temperature of the content was maintained at 50°C. To another container, vinylidene chloride (91.8 parts) and methacrylonitrile (7.3 parts) were weighed and placed to prepare a monomer mixture.
In the pressure resistant reaction vessel, methacrylonitrile (0.4 parts) and methacrylic acid (0.5 parts) were placed and the aforementioned monomer mixture (3 parts) was supplied. Immediately after that, the total amount of remaining monomer mixture (96.1 parts) was continuously added for 16 hours. At this time, sodium hydrogen sulfite (0.1 part) was also added continuously together with the monomer. Immediately after the total amount of monomer mixture was added, the internal pressure started decreasing. The reaction was allowed to proceed until the internal pressure was no longer reduced to obtain a vinylidene chloride emulsion [A].

### [Reference Example 2]

In a pressure resistant reaction vessel provided with glass lining, ion-exchanged water (100 parts), sodium alkyl sulfate (0.1 part) and sodium persulfate (0.9 parts) were placed. After air was purged, the temperature of the content was maintained at 50°C. To another container, vinylidene chloride (89.0 parts) and acrylonitrile (8.5 parts) and methyl methacrylate (1.4 parts) were weighed and added to prepare a monomer mixture.
In the pressure resistant reaction vessel, acrylonitrile (0.5 parts) and acrylic acid (0.6 parts) were placed and the aforementioned monomer mixture (3 parts) was supplied. Immediately after that, the total amount of remaining monomer mixture (95.9 parts) was continuously added for 16 hours. At this time, sodium hydrogen sulfite (0.1 part) was also added continuously together with the monomer. Immediately after the total amount of monomer mixture was added, the internal pressure started decreasing. The reaction was allowed to proceed until the internal pressure was no longer reduced to obtain a vinylidene chloride emulsion [B]

### (Vinylidene chloride lacquer)

### [Reference Example 3]

The water dispersion solution (300 g) of the vinylidene chloride emulsion [A] prepared in Reference Example 1 was added dropwise little by little to a 3% aqueous calcium chloride solution (1000 g) heated to 60°C while stirring. Thereafter, the aggregate generated was washed with water, dried to obtain a white powder.
The vinylidene chloride-based resin powder (50 g) thus obtained was added to a solvent mixture (500 g) of tetrahydrofuran: toluene = 2: 1 and stirred for 30 minutes. After the vinylidene chloride-based resin was completely dissolved, 1.5 g of a urethane-based adhesive (main agent "TAKELAC (registered trade mark) A511" (manufactured by Mitsui Takeda Chemical) /hardening agent "A50" = 10/1) was added and further stirred for 5 minutes to obtain vinylidene chloride lacquer [C].

### (Silicone modified acrylic emulsion)

### [Reference Example 4]

To a reaction container equipped with a stirrer, a reflux condenser, two dripping vessels and a thermometer, water (50.8 parts) and 1 part of "AQUARON KH-10"(registered trade mark, manufactured by Dai-ichi Kogyo Seiyaku Co., Ltd., 25% aqueous solution) were placed. While the temperature of the reaction container was maintained at 80°C, a 2% aqueous ammonium persulfate solution (1.5 parts) was added.
Five minutes after the addition, as a step (1), an emulsified liquid, which was prepared by mixing methyl methacrylate (3.378 parts), cyclohexyl methacrylate (14.5 parts), n-butyl methacrylate (17.5 parts), butyl acrylate (14 parts), methacrylic acid (0.622 parts), 1.2 parts of "TINUVIN 384" (registered trade mark, manufactured by Nihon Ciba-Geigy K.K.), 0.6 parts of "TINUVIN 123"(registered trade mark, manufactured by Nihon Ciba-Geigy K.K.), "AQUARON KH-10" (3 parts), 2 parts of "EMULGEN 120" (registered trade mark, manufactured by Kao Corp., 20% aqueous solution), a 2% aqueous ammonium persulfate solution (2.5 parts) and water (22.6 parts) by a homomixer for 5 minutes, and a solution mixture, which was composed of γ-methacryloxypropyl trimethoxysilane (0.578 parts), methyl trimethoxysilane (2.111 parts) and dimethyldimethoxysilane (3.378 parts), were added dropwise from discrete dripping vessels to the reaction container for 90 minutes.
The temperature of the reaction container was maintained at 80°C for 30 minutes. Then, as a step (2), an emulsified liquid, which was prepared by mixing methyl methacrylate (5.25 parts), cyclohexyl methacrylate (6 parts), n-butyl methacrylate (7 parts), butyl acrylate (0.4 parts), methacrylic acid (0.5 parts), acrylic acid (0.5 parts), 2-hydroxyethyl methacrylate (0.15 parts), acrylamide (0.2 parts), "AQUARON KH-10" (0.6 parts), a 2% aqueous ammonium persulfate solution (1 part) and water (14.6 parts) by a homomixer for 5 minutes, was added dropwise from a dripping vessel to the reaction container for 45 minutes.
The temperature of the reaction container was maintained at 80°C for 30 minutes. Then, as a step (3), an emulsified liquid, which was prepared by mixing methyl methacrylate (6.822 parts), cyclohexyl methacrylate (9 parts), n-butyl methacrylate (10.5 parts), butyl acrylate (3.3 parts), methacrylic acid (0.378 parts), "TINUVIN 384" (0.8 parts), "TINUVIN 123" (0.4 parts), "AQUARON KH-10" (0.9 parts), a 2% aqueous ammonium persulfate solution (1.5 parts) and water (14.6 parts) by a homomixer for 5 minutes, and a solution mixture, which was composed of γ-methacryloxypropyltrimethoxysilane (0.138 parts), methyltrimethoxysilane (1.267 parts) and dimethyldimethoxysilane (2.022 parts), were added dropwise from discrete dripping vessels to the reaction container for 60 minutes.
The temperature of the reaction container was maintained at 80°C for 90 minutes and thereafter cooled to room temperature. As hydrogen ion concentration was measured, it was pH 2.3. A 25% aqueous ammonia solution was added to adjust pH to 8.5 to obtain a silicone-modified acrylic emulsion [a].

### [Reference Example 5]

To a reaction container equipped with a stirrer, a reflux condenser, two dripping vessels and a thermometer, water (59.5 parts) and 3.2 parts of "ADEKA REASOAP SR-10N" (manufactured by ADEKA Corp., 25% aqueous solution) were placed. While the temperature of the reaction container was maintained at 80°C, a 2% aqueous ammonium persulfate solution (1.5 parts) was added.
Five minutes after the addition, as a step (1), an emulsified liquid, which was prepared by mixing methyl methacrylate (11.375 parts), cyclohexyl methacrylate (5 parts), n-butyl methacrylate (17.5 parts), 2-ethylhexyl acrylate (15.5 parts), acrylic acid (0.625 parts), "ADEKA REASOAP SR-10N" (2 parts), "EMULGEN 120" (2 parts), a 2% aqueous ammonium persulfate solution (1.25 parts) and water (30.1 parts) by a homomixer for 5 minutes, and a solution mixture, which was composed of γ-methacryloxypropyltrimethoxysilane (0.578 parts), methyltrimethoxysilane (2.111 parts) and dimethyldimethoxysilane (3.378 parts), were added dropwise from discrete dripping vessels to the reaction container for 90 minutes.
The temperature of the reaction container was maintained at 80°C for 30 minutes. Then, as a step (2), an emulsified liquid, which was prepared by mixing styrene (1 part), methyl methacrylate (7.8 parts), cyclohexyl methacrylate (2 parts), n-butyl methacrylate (7 parts), 2-ethylhexyl acrylate (1 part), methacrylic acid (0.5 parts), acrylic acid (0.5 parts), acrylamide (0.2 parts), "ADEKA REASOAP SR-10N" (0.4 parts) a 2% aqueous ammonium persulfate solution (0.5 parts) and water (19.2 parts) by a homomixer for 5 minutes, was added dropwise from a dripping vessel to the reaction container for 45 minutes.
The temperature of the reaction container was maintained at 80°C for 30 minutes. Then, as a step (3), an emulsified liquid, which was prepared by mixing methyl methacrylate (14.7 parts), cyclohexyl methacrylate (3 parts), n-butyl methacrylate (10.5 parts), 2-ethylhexyl acrylate (1.425 parts), acrylic acid (0.375 parts), "TINUVIN 400" (1 part), "TINUVIN 123" (0.5 parts), "ADEKA REASOAP SR-10N" (0.6 parts), a 2% aqueous ammonium persulfate solution (0.75 parts) and water (218.3 parts) by a homomixer for 5 minutes, and a solution mixture, which was composed of γ-methacryloxypropyltrimethoxysilane (0.138 parts), methyltrimethoxysilane (1.267 parts) and dimethyldimethoxysilane (2.022 parts) were added dropwise from discrete dripping vessels to the reaction container for 60 minutes.
The temperature of the reaction container was maintained at 80°C for 90 minutes and thereafter cooled to room temperature. As hydrogen ion concentration was measured, it was pH 2.4. A 25% aqueous ammonia solution was added to adjust pH to 8.5 to obtain a silicone-modified acrylic emulsion [b].

### [Reference Example 6]

To a reaction container equipped with a stirrer, a reflux condenser, two dripping vessels and a thermometer, water (50.8 parts) and 1.33 parts of "Newcol 707SF" (manufactured by Nippon Nyukazai Co., Ltd., 30% aqueous solution) were placed. While the temperature of the reaction container was maintained at 80°C, a 2% aqueous ammonium persulfate solution (1.5 parts) was added.
Five minutes after the addition, as a step (1), an emulsified liquid, which was prepared by mixing methyl methacrylate (3.875 parts), cyclohexyl methacrylate (25 parts), butyl acrylate (20.5 parts), methacrylic acid (0.625 parts), "Newcol 707SF" (2.5 parts), "EMULGEN 120" (2 parts), a 2% aqueous ammonium persulfate solution (2.5 parts), water (24.5 parts) by a homomixer for 5 minutes, and a solution mixture, which was composed of γ-methacryloxypropyltrimethoxysilane (0.353 parts), methyltrimethoxysilane (1.277 parts) and dimethyldimethoxysilane (2.038 parts), were added dropwise from discrete dripping vessels to the reaction container for 90 minutes.
The temperature of the reaction container was maintained at 80°C for 30 minutes. Then, as a step (2), an emulsified liquid, which was prepared by mixing methyl methacrylate (4.37 parts), cyclohexyl methacrylate (10 parts), n-butyl methacrylate (0.1 part), butyl acrylate (2.33 parts), methacrylic acid (0.5 parts), acrylic acid (0.5 parts), 2-hydroxyethyl methacrylate (2 parts), acrylamide (0.2 parts), "Newcol 707SF" (1 part), a 2% aqueous ammonium persulfate solution (1 part) and water (14.4 parts) by a homomixer for 5 minutes, was added dropwise from a dripping vessel to the reaction container for 45 minutes.
The temperature of the reaction container was maintained at 80°C for 30 minutes. Then, as a step (3), an emulsified liquid, which was prepared by mixing methyl methacrylate (3.165 parts), cyclohexyl methacrylate (15 parts), butyl acrylate (10.86 parts), methacrylic acid (0.375 parts), 2-hydroxyethyl methacrylate (0.6 parts), "TINUVIN 123" (0.49 parts), "Newcol 707SF" (1 part), "AQUARON KH-10" (0.24 parts), a 2% aqueous ammonium persulfate solution (1.5 parts), water (15.2 parts) by a homomixer for 5 minutes, and a solution mixture, which was composed of γ-methacryloxypropyltrimethoxysilane (0.084 parts), methyltrimethoxysilane (0.761 part) and dimethyldimethoxysilane (1.223 parts), were added dropwise from discrete dripping vessels to the reaction container for 60 minutes.
The temperature of the reaction container was maintained at 80°C for 90 minutes and thereafter cooled to room temperature. As hydrogen ion concentration was measured, it was pH 2.3. A 25% aqueous ammonia solution was added to adjust pH to 8.5 to obtain a silicone-modified acrylic emulsion [c].

### [Reference Example 7]

To a reaction container equipped with a stirrer, a reflux condenser, two dripping vessels and a thermometer, water (59.6 parts) and "ADEKA REASOAP SR-10N" (3.2 parts) were placed. While the temperature of the reaction container was maintained at 80°C, a 2% aqueous ammonium persulfate solution (1.5 parts) was added.
Five minutes after the addition, as a step (1), an emulsified liquid, which was prepared by mixing methyl methacrylate (11.381 parts), cyclohexyl methacrylate (5 parts), n-butyl methacrylate (17.5 parts), 2-ethylhexyl acrylate (15.5 parts), acrylic acid (0.619 parts), "ADEKA REASOAP SR-10N" (2 parts), "EMULGEN 120" (2 parts), a 2% aqueous ammonium persulfate solution (1.25 parts) and water (30.0 parts) by a homomixer for 5 minutes, and a solution mixture, which was composed of methyltrimethoxysilane (0.417 parts) and dimethyldimethoxysilane (0.685 parts), were added dropwise from discrete dripping vessels to the reaction container for 90 minutes.
The temperature of the reaction container was maintained at 80°C for 30 minutes. Then, as a step (2), an emulsified liquid, which was prepared by mixing styrene (1 part), methyl methacrylate (7.8 parts), cyclohexyl methacrylate (2 parts), n-butyl methacrylate (7 parts), 2-ethylhexyl acrylate (1 part), methacrylic acid (0.5 parts), acrylic acid (0.5 parts), acrylamide (0.2 parts), "ADEKA REASOAP SR-10N" (0.4 parts), a 2% aqueous ammonium persulfate solution (0.5 parts) and water (19.2 parts) by a homomixer for 5 minutes, was added dropwise from a dripping vessel to the reaction container for 45 minutes.
The temperature of the reaction container was maintained at 80°C for 30 minutes. Then, as a step (3), an emulsified liquid, which was prepared by mixing methyl methacrylate (14.7 parts), cyclohexyl methacrylate (3 parts), n-butyl methacrylate (10.5 parts), 2-ethylhexyl acrylate (1.425 parts), acrylic acid (0.375 parts), "TINUVIN 400" (1 part), "TINUVIN 123" (0.5 parts), "ADEKA REASOAP SR-10N" (0.6 parts), a 2% aqueous ammonium persulfate solution (0.75 parts) and water (218 parts) by a homomixer for 5 minutes, and a solution mixture, which was composed of methyltrimethoxysilane (0.67 parts) and dimethyldimethoxysilane (1.09 parts), were added dropwise from discrete dripping vessels to the reaction container for 60 minutes.
The temperature of the reaction container was maintained at 80°C for 90 minutes and thereafter cooled to room temperature. As hydrogen ion concentration was measured, it was pH 2.4. A 25% aqueous ammonia solution was added to adjust pH to 8.5 to obtain a silicone-modified acrylic emulsion [d].

### [Reference Example 8]

To a reaction container equipped with a stirrer, a reflux condenser, two dripping vessels and a thermometer, water (164.9 parts) was placed. After the temperature of the reaction maintained at 70°C, as a step (1), an emulsified liquid, which was prepared by mixing methyl methacrylate (2.4 parts), cyclohexyl methacrylate (9 parts), n-butyl methacrylate (3 parts), butyl acrylate (15 parts), methacrylic acid (0.6 parts), "AQUARON KH-10" (8.8 parts), "EMULGEN 120" (3 parts) and water (34.4 parts) by a homomixer for 5 minutes, and γ-methacryloxypropyltrimethoxysilane (0.583 parts), methyltrimethoxysilane (33.52 parts), dimethyldimethoxysilane (21.423 parts) and phenyltrimethoxysilane (5.057 parts) were added. While the temperature of the reaction container was maintained at 70°C, a 2% aqueous ammonium persulfate solution (4.5 parts) was added and thereafter the temperature of the reaction container was adjusted for 60 minutes so as to reach 80°C.
While the temperature of the reaction container was maintained at 80°C, then as a step (2), an emulsified liquid, which was prepared by mixing methyl methacrylate (22.5 parts), cyclohexyl methacrylate (21 part), n-butyl methacrylate (7 parts), butyl acrylate (13 parts), methacrylic acid (2.1 part), acrylic acid (1.4 parts), 2-hydroxyethyl methacrylate (2.8 parts), acrylamide (0.2 parts), "TINUVIN 400" (1 part), "TINUVIN 123" (0.5 parts), "AQUARON KH-10" (3.2 parts), "EMULGEN 120" (2 parts) and water (45.1 parts) by a homomixer for 5 minutes, and a solution mixture, which was composed of γ-methacryloxypropyltrimethoxysilane (0.133 parts), methyltrimethoxysilane (22.346 parts), dimethyldimethoxysilane (14.282 parts) and phenyltrimethoxysilane (3.371 part), were added dropwise from discrete dripping vessels to the reaction container for 90 minutes.
The temperature of the reaction container was maintained at 80°C for 90 minutes, and cooled to room temperature. As hydrogen ion concentration was measured, it was pH 2.7. To the solution mixture, a 25% aqueous ammonia solution was added to adjust pH to 10. Thereafter, the solution mixture was returned again to a reaction container whose pressure can be reduced and heated for at 80°C for 3 hours. Further subsequently, an appropriate amount of defoaming agent was added and then the interior pressure of the container was reduced to 40kPa to perform concentration until a solid content reached to 45%. After the temperature was cooled to room temperature, hydrogen ion concentration was measured. It was pH 7.9. Thereafter, a 25% aqueous ammonia solution was added to adjust pH to 8.5 to obtain a silicone-modified acrylic emulsion [e].

### [Reference Example 9]

To a reaction container equipped with a stirrer, a reflux condenser, two dripping vessels and a thermometer, water (97.5 parts) and 4 parts of "AQUARON HS-10" (registered trade mark, manufactured by Dai-ichi Kogyo Seiyaku Co., Ltd., 25% aqueous solution) were placed. The temperature of the reaction container was maintained at 80°C and a 2% aqueous ammonium persulfate solution (1.5 parts) was added.
Five minutes after the addition, as a step (1), an emulsified liquid, which was prepared by mixing methyl methacrylate (18.3 parts), n-butyl methacrylate (11 parts), butyl acrylate (20.1 parts), acrylic acid (0.6 parts), "TINUVIN 400" (3.5 parts), "TINUVIN 123" (1.75 parts), "AQUARON HS-10" (6.4 parts), "EMULGEN 120" (2 parts), a 2% aqueous ammonium persulfate solution (2.5 parts) and water (76.4 parts) by a homomixer for 5 minutes, and a solution mixture, which was composed of γ-methacryloxypropyl trimethoxysilane (0.537 parts), methyltrimethoxysilane (54.825 parts), dimethyldimethoxysilane (21.9 parts) and diphenyldimethoxysilane (5.55 parts), were added dropwise from discrete dripping vessels to the reaction container for 90 minutes.
The temperature of the reaction container was maintained at 80°C for 30 minutes. Then, as a step (2), an emulsified liquid, which was prepared by mixing methyl methacrylate (7 parts), cyclohexyl methacrylate (7 parts), n-butyl methacrylate (2.9 parts), methacrylic acid (1.5 parts), acrylic acid (0.4 parts), 2-hydroxyethyl methacrylate (1 part), acrylamide (0.2 parts), "AQUARON HS-10" (4 parts), a 2% aqueous ammonium persulfate solution (1 part) and water (31.8 parts) by a homomixer for 5 minutes, was added dropwise from a dripping vessel to the reaction container for 45 minutes.
The temperature of the reaction container was maintained at 80°C for 30 minutes. Then, as a step (3), an emulsified liquid, which was prepared by mixing methyl methacrylate (10.4 parts), cyclohexyl methacrylate (13 parts), n-butyl methacrylate (6.1 parts), acrylic acid (0.5 parts), "TINUVIN 400" (1.5 parts), "TINUVIN 123" (0.75 parts), "AQUARON HS-10" (0.3 parts), a 2% aqueous ammonium persulfate solution (1.5 parts) and water (36.4 parts) by a homomixer for 5 minutes, and a solution mixture, which was composed of γ-methacryloxypropyl trimethoxysilane (0.179 parts), methyltrimethoxysilane (18.275 parts), dimethyldimethoxysilane (7.3 parts) and diphenyldimethoxysilane (1.85 parts), were added dropwise from discrete dripping vessels to the reaction container for 60 minutes.
The temperature of the reaction container was maintained at 80°C for 90 minutes and thereafter cooled to room temperature. As hydrogen ion concentration was measured, it was pH 2.6. To the solution mixture, a 25% aqueous ammonia solution was added to adjust pH to 10, thereafter the solution mixture was returned again to a reaction container whose pressure can be reduced and heated for at 80°C for 3 hours. Further subsequently, an appropriate amount of defoaming agent was added and then the interior pressure of the container was reduced to 40kPa to perform concentration until a solid content reached to 45%. After the temperature was cooled to room temperature, hydrogen ion concentration was measured. It was pH 8.0. Thereafter, a 25% aqueous ammonia solution was added to adjust pH to 8.5 to obtain a silicone-modified acrylic emulsion [f].

### [Reference Example 10]

To a reaction container equipped with a stirrer, a reflux condenser, a dripping vessel and a thermometer, water (100 parts) and sodium dodecylbenzene sulfonate (5 parts) were placed. The temperature of the reaction container was maintained at 85°C. Next, a mixture composed of 85 parts of "DIMETHYLCYCLIX" (a cyclic dimethylsiloxane oligomer 3 to 7 dimer mixture), γ-methacryloxypropyltrimethoxysilane (15 parts), sodium dodecylbenzene sulfonate (0.7 parts) and water (300 parts) was preliminary mixed by a homomixer. Thereafter, a silicone emulsified liquid, which was sheared by a homogenizer at a pressure of 350 kg/cm², was added dropwise from a dripping vessel to the reaction container for 3 hours. After completion of the dropwise addition, the mixture was maintained at 85°C, heated for a further one hour and cooled to room temperature. The mixture was neutralized with an aqueous sodium hydroxide solution to obtain a silicone emulsion.
Furthermore, the silicone emulsion (62 parts), 1 part of "LATEMUL S-180A"(registered trade mark, manufactured by Kao Corp., 20% aqueous solution) and water (85 parts) were placed in another reaction container and heated to 70°C and then a 2% aqueous ammonium persulfate solution (3 parts) was added. Five minutes after the addition, a mixture of methyl methacrylate (32 parts), n-butyl methacrylate (30 parts), 2-ethylhexyl acrylate (23 parts), 2-hydroxyethyl methacrylate (10 parts), diacetone acrylamide (3 parts), methacrylic acid (2 parts), γ-methacryloxypropyltrimethoxysilane (2 parts), "TINUVIN 400" (0.5 parts) and "TINUVIN 123" (0.25 parts) was added dropwise for 4 hours.
After the temperature of the reaction container was maintained at 70°C for 1 hour, further increased to 80°C, maintained for 1 hour and cooled to room temperature. A 25% by mass aqueous ammonia solution was added to adjust pH to 8.5 to obtain a silicone-modified acrylic emulsion [g].

### [Reference Example 11]

To a reaction container equipped with a stirrer, a reflux condenser, a dripping vessel and a thermometer, water (70 parts) and 0.8 parts of "ADEKA REASOAP SE-1025A" (manufactured by ADEKA Corp., 25% aqueous solution) were placed. The temperature of the reaction container was maintained at 80°C and a 2% aqueous ammonium persulfate solution (15 parts) was added.
Five minutes after the addition, as a step (1), an emulsified liquid, which was prepared by mixing methyl methacrylate (25 parts), cyclohexyl methacrylate (40 parts), butyl acrylate (15 parts), 2-ethylhexyl acrylate (15 parts), 2-hydroxyethyl methacrylate (2 parts), acrylic acid (3 parts), "TINUVIN 400" (0.5 parts), "TINUVIN 123" (0.25 parts), "ADEKA REASOAP SE-1025A" (4 parts) and water (30 parts) by a homomixer for 5 minutes, was added dropwise from a dripping vessel to the reaction container for 3 hours.
Thereafter, the temperature of the reaction container was increased to 90°C, maintained for 2 hours, and cooled to room temperature. A 25% aqueous ammonia solution was added to adjust pH to 7.
Subsequently, as a step (2), γ-glycidoxypropyldimethoxymethylsilane (1 part) and γ-glycidoxypropyltriethoxysilane (2 parts) were added and vigorously stirred for 1 hour. Next, methyltriethoxysilane (6 parts) and tetraethoxysilane (2 parts) were added, increased to a temperature of 70°C and continuously stirred for 3 hours to perform polycondensation. Thereafter, the mixture was cooled to room temperature to obtain a silicone-modified acrylic emulsion [h].

### [Reference Example 12]

To a reaction container equipped with a stirrer, a reflux condenser, a dripping vessel and a thermometer, water (77.7 parts), "ADEKA REASOAP SR-10N" (2.4 parts), 2.4 parts of "EMULGEN 1108S"(registered trade mark, manufactured by Kao Corp., 25% aqueous solution) and styrene (1 part) were placed. The temperature of the reaction container was increased to 70°C.
As a step (1), an emulsified liquid was prepared by mixing methyl methacrylate (21.9 parts), cyclohexyl methacrylate (10 parts), 2-ethylhexyl acrylate (15.6 parts), acrylic acid (1.5 parts), "ADEKA REASOAP SR-10N" (1.8 parts), "EMULGEN 1108S" (1.8 parts) and water (17.3 parts) by a homomixer for 5 minutes. After 14.1 parts of the emulsified liquid was supplied from a dripping vessel to the reaction container, a 5% aqueous potassium persulfate solution (4.2 parts) was added to initiate polymerization; at the same time, the temperature of the reaction container was increased to 80°C for 15 minutes. Thereafter, the reaction was conducted further at 80°C for 30 minutes. While the mixture was maintained at 80°C, the remaining emulsified liquid (55.8 parts) was further added dropwise for 80 minutes from the dripping vessel to the reaction container. After the dropwise addition, the mixture was maintained at 80°C for 30 minutes, and further a 25% aqueous ammonia solution (1.05 parts) was added and maintained further for 10 minutes.
Subsequently, as a step (2), an emulsified liquid, which was prepared by mixing methyl methacrylate (25.5 parts), cyclohexyl methacrylate (10 parts), 2-ethylhexyl acrylate (15.5 parts), 0.5 parts of "ADEKA STUB LA82" (manufactured by ADEKA Corp.), γ-methacryloxypropyltrimethoxysilane (0.5 parts), "ADEKA REASOAP SR-10N" (1.8 parts), "EMULGEN 1108S" (1.8 parts) and water (17.3 parts) by a homomixer for 5 minutes, was added dropwise from a dripping vessel to the reaction container at 80°C for 100 minutes.
Also after the dropwise addition, the mixture was maintained at 80°C for 60 minutes. Thereafter, the mixture was cooled to room temperature to obtain a silicone-modified acrylic emulsion [i].

### [Reference Example 13]

To a reaction container equipped with a stirrer, a reflux condenser, a dripping vessel and a thermometer, water (59.6 parts) and "ADEKA REASOAP SR-10N" (3.2 parts) were placed. The temperature of the reaction container was maintained at 80°C and a 2% aqueous ammonium persulfate solution (1.5 parts) was added.
Five minutes after the addition, as a step (1), an emulsified liquid, which was prepared by mixing methyl methacrylate (11.381 parts), cyclohexyl methacrylate (5 parts), n-butyl methacrylate (17.5 parts), 2-ethylhexyl acrylate (15.5 parts), acrylic acid (0.619 parts), "ADEKA REASOAP SR-10N" (2 parts), "EMULGEN 120" (2 parts), a 2% aqueous ammonium persulfate solution (1.25 parts) and water (30.0 parts) by a homomixer for 5 minutes, was added dropwise from a dripping vessel to the reaction container for 90 minutes.
The temperature of the reaction container was maintained at 80°C for 30 minutes. Then, as a step (2), an emulsified liquid, which was prepared by mixing styrene (1 part), methyl methacrylate (7.8 parts), cyclohexyl methacrylate (2 parts), n-butyl methacrylate (7 parts), 2-ethylhexyl acrylate (1 part), methacrylic acid (0.5 parts), acrylic acid (0.5 parts), acrylamide (0.2 parts), "ADEKA REASOAP SR-10N" (0.4 parts), a 2% aqueous ammonium persulfate solution (0.5 parts) and water (19.2 parts) by a homomixer for 5 minutes, was added dropwise from a dripping vessel to the reaction container for 45 minutes.
The temperature of the reaction container was maintained at 80°C for 30 minutes. Then, as a step (3), an emulsified liquid, which was prepared by mixing methyl methacrylate (14.7 parts), cyclohexyl methacrylate (3 parts), n-butyl methacrylate (10.5 parts), 2-ethylhexyl acrylate (1.425 parts), acrylic acid (0.375 parts), "TINUVIN 400" (1 part), "TINUVIN 123" (0.5 parts), "ADEKA REASOAP SR-10N" (0.6 parts), a 2% aqueous ammonium persulfate solution (0.75 parts) and water (218 parts) by a homomixer for 5 minutes, was added dropwise from a dripping vessel to the reaction container for 60 minutes.
The temperature of the reaction container was maintained at 80°C for 90 minutes and thereafter cooled to room temperature. As hydrogen ion concentration was measured, it was pH 2.4. A 25% aqueous ammonia solution was added to adjust pH to 8.5 to obtain an acrylic emulsion. To the acrylic emulsion (100 parts), 2 parts of a silicone emulsion "KM-785" (manufactured by Shin-Etsu Chemical Co., Ltd.) was blended to obtain a silicone-modified acrylic emulsion [j].

### (Acrylic emulsion)

### [Reference Example 14]

To a reaction container equipped with a stirrer, a reflux condenser, two dripping vessels and a thermometer, water (50.8 parts) and 1 part of "AQUARON KH-10" (registered trade mark, manufactured by Dai-ichi Kogyo Seiyaku Co., Ltd., 25% aqueous solution) were placed. The temperature of the reaction container was maintained at 80°C and a 2% aqueous ammonium persulfate solution (1.5 parts) was added.
Five minutes after the addition, as a step (1), an emulsified liquid, which was prepared by mixing methyl methacrylate (3.378 parts), cyclohexyl methacrylate (14.5 parts), n-butyl methacrylate (17.5 parts), butyl acrylate (14 parts), methacrylic acid (0.622 parts), 1.2 parts of "TINUVIN 384"(registered trade mark, manufactured by Nihon Ciba-Geigy K.K.), 0.6 parts of "TINUVIN 123" (registered trade mark, manufactured by Nihon Ciba-Geigy K.K.), "AQUARON KH-10" (3 parts), 2 parts of "EMULGEN 120" (registered trade mark, manufactured by Kao Corp., 20% aqueous solution), a 2% aqueous ammonium persulfate solution(2.5 parts) and water (22.6 parts) by a homomixer for 5 minutes, was added dropwise from a dripping vessel to the reaction container for 90 minutes.
The temperature of the reaction container was maintained at 80°C for 30 minutes. Then, as a step (2), an emulsified liquid, which was prepared by mixing methyl methacrylate (5.25 parts), cyclohexyl methacrylate (6 parts), n-butyl methacrylate (7 parts), butyl acrylate (0.4 parts), methacrylic acid (0.5 parts), acrylic acid (0.5 parts), 2-hydroxyethyl methacrylate (0.15 parts), acrylamide (0.2 parts), "AQUARON KH-10" (0.6 parts), a 2% aqueous ammonium persulfate solution (1 part) and water (14.6 parts) by a homomixer for 5 minutes, was added dropwise from a dripping vessel to the reaction container for 45 minutes.
The temperature of the reaction container was maintained at 80°C for 30 minutes. Then, as a step (3), an emulsified liquid, which was prepared by mixing methyl methacrylate (6.822 parts), cyclohexyl methacrylate (9 parts), n-butyl methacrylate (10.5 parts), butyl acrylate (3.3 parts), methacrylic acid (0.378 parts), "TINUVIN 384" (0.8 parts), "TINUVIN 123" (0.4 parts), "AQUARON KH-10" (0.9 parts), a 2% aqueous ammonium persulfate solution (1.5 parts) and water (14.6 parts) by a homomixer for 5 minutes, was added dropwise from a dripping vessel to the reaction container for 60 minutes.
The temperature of the reaction container was maintained at 80°C for 90 minutes and thereafter cooled to room temperature. As hydrogen ion concentration was measured, it was pH 2.3. A 25% aqueous ammonia solution was added to adjust pH to 8.5 to obtain an acrylic emulsion [k].

Examples of a method for producing a paint in which a silicone-modified acrylic emulsion is mixed with a pigment will be described as Reference Examples, below.

### (Pigment paste)

### [Reference Example 15]

To a 1L stainless-steel container, 10.5 g of a dispersant (20% product of SN-Dispersant 5027, manufactured by San Nopco Limited), propylene glycol (49 g), water (310.42 g) and ammonia water (1 g of a 25% product) were placed and stirred by a three-one motor. While stirring, 700 g of titanium oxide (Tipure R-706) was placed and further 6 g of a defoaming agent (SND-1310) was added and stirred for 30 minutes.
To the slurry stirred, 1 kg of glass beads (spherical beads of 1 mm in diameter) was placed. The slurry was further dispersed by a batch-type desktop sand mill (manufactured by Kanpe Hapio Co., Ltd.) equipped with 4 dispersion disks, at 1490 rpm for 20 minutes to obtain pigment paste [A] having a pigment concentration of 65%.

### [Reference Example 16]

Pigment paste [B] was obtained in the same manner as in Reference Example 15 except that zinc oxide was used in place of the titanium oxide.

### [Reference Example 17]

Pigment paste [C] was obtained in the same manner as in Reference Example 15 except that calcium carbonate (brilliant 15) was used in place of the titanium oxide.

### (Enamel paint)

### [Reference Example 18]

To 54.35 g of the silicone-modified acrylic emulsion [a] (solid content: 40%), 5 g of a film-forming auxiliary (butyl cellosolve/water = 1/1) was added while stirring and stirred for 10 minutes. To this, 5 g of a film-forming auxiliary (CS-12(texanol/manufactured by Chisso Corporation)) was added and stirred for a further 10 minutes. Thereafter, further 25.64 g of pigment paste [A] (pigment concentration: 65%) and 0.6 g of Adecanol UH-438 (10%) were added and stirred for 5 minutes to obtain an enamel paint [1](PWC = 40%).

### [Reference Example 19]

Enamel paint [2] was obtained in the same manner as in Reference Example 18 except that pigment paste [B] was used.

### [Reference Example 20]

Enamel paint [3] was obtained in the same manner as in Reference Example 18 except that pigment paste [C] was used.

Using vinylidene chloride emulsions [A], [B] and vinylidene chloride lacquer [C] obtained in Reference Examples 1 to 3, silicone-modified emulsions [a] to [k] obtained in Reference Examples 4 to 14 and Enamel paints [1] to [3] obtained in Reference Examples 18 to 20, solar battery back-sheets were produced as described below.
Furthermore, using the solar battery back-sheets, solar battery modules were produced.

### [Example 1]

Onto one of surfaces of a hydrolysis-resistant polyester film "LUMIRROR X10S"(registered trade mark, manufactured by Toray Industries Inc., thickness: 188 µm), a urethane-based adhesive (main agent: "TAKELAC (manufactured by Mitsui Takeda Chemical (registered trade mark)) A511"/hardening agent "A50" = 10/1) was applied in a coating amount of 5 g/m² by a gravure coater.
Subsequently, vinylidene chloride emulsion [A] was applied by an air knife coater such that a thickness of a vinylidene chloride-based resin layer becomes 11 µm.
After hardening was performed at 40°C for 48 hours, silicone-modified acrylic emulsion [a] was subsequently applied by a die coater such that the thickness of the silicone-modified acrylic-based resin layer becomes 54 µm to obtain a solar battery back-sheet as shown in Figure 1.
Next, using a glass layer to which sunlight was to be applied as a front surface, the solar battery back-sheet as a rear surface and an ethylene-vinyl acetate copolymer resin "SOLAR EVA" (Mitsui Chemicals Fabro, Inc.) as a filler, solar battery elements were sandwiched to obtain a solar battery module using the solar battery back-sheet as shown in Figure 2.

### [Example 2]

A solar battery back-sheet and a solar battery module were obtained in the same manner as in Example 1 except that coating was made such that the thickness of the vinylidene chloride-based resin layer became 25 µm.

### [Example 3]

A solar battery back-sheet and a solar battery module were obtained in the same manner as in Example 1 except that coating was made such that the thickness of the silicone-modified acrylic-based resin layer became 81 µm.

### [Example 4]

A solar battery back-sheet and a solar battery module were obtained in the same manner as in Example 1 except that silicone-modified acrylic emulsion [b] was used.

### [Example 5]

A solar battery back-sheet and a solar battery module were obtained in the same manner as in Example 1 except that silicone-modified acrylic emulsion [c] was used.

### [Example 6]

A solar battery back-sheet and a solar battery module were obtained in the same manner as in Example 1 except that vinylidene chloride emulsion [B] and silicone-modified acrylic emulsion [d] were used.

### [Example 7]

A solar battery back-sheet and a solar battery module were obtained in the same manner as in Example 1 except that vinylidene chloride emulsion [B] and silicone-modified acrylic emulsion [e] were used.

### [Example 8]

A solar battery back-sheet and a solar battery module were obtained in the same manner as in Example 1 except that vinylidene chloride emulsion [B] and silicone-modified acrylic emulsion [f] were used.

### [Example 9]

A solar battery back-sheet and a solar battery module were obtained in the same manner as in Example 1 except that vinylidene chloride emulsion [B] and silicone-modified acrylic emulsion [g] were used.

### [Example 10]

A solar battery back-sheet and a solar battery module were obtained in the same manner as in Example 1 except that vinylidene chloride emulsion [B] and silicone-modified acrylic emulsion [h] were used.

### [Example 11]

A solar battery back-sheet and a solar battery module were obtained in the same manner as in Example 1 except that vinylidene chloride emulsion [B] and silicone-modified acrylic emulsion [i] were used.

### [Example 12]

A solar battery back-sheet and a solar battery module were obtained in the same manner as in Example 1 except that a plastic base formed of a polyester film "COSMOSHINE A4100" (manufactured by Toyobo Co., Ltd., thickness: 188 µm) and silicone-modified acrylic emulsion [j] were used.

### [Example 13]

A solar battery back-sheet and a solar battery module were obtained in the same manner as in Example 1 except that the silicone-modified acrylic emulsion was enamel paint [1].

### [Example 14]

A solar battery back-sheet and a solar battery module were obtained in the same manner as in Example 1 except that the silicone-modified acrylic emulsion was enamel paint [2].

### [Example 15]

A solar battery back-sheet and a solar battery module were obtained in the same manner as in Example 1 except that the silicone-modified acrylic emulsion was enamel paint [3].

### [Example 16]

To a hydrolysis-resistant polyester film "LUMIRROR X10S"(registered trade mark, manufactured by Toray Industries Inc., thickness: 188 µm), vinylidene chloride lacquer [C] was applied by a bar coater such that a thickness of a vinylidene chloride-based resin layer became 5 µm and dried in an oven maintained at 120°C for 60 seconds.
After hardening was performed at 40°C for 48 hours, silicone-modified acrylic emulsion [a] was subsequently applied by a die coater such that the thickness of the silicone-modified acrylic-based resin layer became 54 µm to obtain a solar battery back-sheet having the same structure as shown in Figure 1 except that the adhesive layer was not present.
Next, using a glass layer to which sunlight was to be applied as a front surface, the solar battery back-sheet as a rear surface, and a ethylene-vinyl acetate copolymer resin "SOLAR EVA"(Mitsui Chemicals Fabro, Inc.) as a filler, solar battery elements were sandwiched to obtain a solar battery module using the solar battery back-sheet as shown in Figure 2.

### [Comparative Example 1]

Onto one of surfaces of a hydrolysis-resistant polyester film "LUMIRROR X10S"(registered trade mark, manufactured by Toray Industries Inc., thickness: 188 µm), a urethane-based adhesive (main agent: "TAKELAC (manufactured by Mitsui Takeda Chemical (registered trade mark)) A511"/hardening agent "A50" = 10/1) was applied in a coating amount of 5 g/m² by a gravure coater.
Subsequently, vinylidene chloride emulsion [B] was applied by an air knife coater such that a thickness of a vinylidene chloride-based resin layer becomes 10 µm to obtain a solar battery back-sheet.
Next, a solar battery module was obtained in the same manner as in Example 1.

### [Comparative Example 2]

Onto one of surfaces of a hydrolysis-resistant polyester film "LUMIRROR X10S"(registered trade mark, manufactured by Toray Industries Inc., thickness: 188 µm), a urethane adhesive (main agent: "TAKELAC (manufactured by Mitsui Takeda Chemical (registered trade mark)) A511"/hardening agent "A50" = 10/1) was applied in a coating amount of 5 g/m² by a gravure coater.
Subsequently, silicone-modified acrylic emulsion [b] was applied by a die coater such that a thickness of a silicone-modified acrylic-based resin layer becomes 52 µm to obtain a solar battery back-sheet.
Next, a solar battery module was obtained in the same manner as in Example 1.

### [Comparative Example 3]

Onto one of surfaces of a high weather-resistant fluorine resin film (registered trade mark "TEDLAR" manufactured by Du Pont, thickness: 50 µm), a urethane-based adhesive (main agent: "TAKELAC (manufactured by Mitsui Takeda Chemical (registered trade mark)) A511"/hardening agent "A50" = 10/1) was applied in a coating amount of 5 g/m² by a gravure coater. Thereafter, an aluminum foil of 20 µm in thickness was laminated via the adhesive layer. Further, to a similar aluminum foil, the aforementioned urethane-based adhesive was applied and the high weather-resistant fluorine resin film ("TEDLAR", thickness: 50 µm) was jointed to form a laminate. In this manner, a solar battery back-sheet of a three-layer structure: fluorine resin film/aluminum foil/fluorine resin film, was obtained.
Next, a solar battery module was obtained in the same manner as in Example 1.

### [Comparative Example 4]

Onto one of surfaces of a hydrolysis-resistant polyester film "LUMIRROR X10S"(registered trade mark, manufactured by Toray Industries Inc., thickness: 60 µm), a urethane-based adhesive (main agent: "TAKELAC (manufactured by Mitsui Takeda Chemical (registered trade mark)) A511"/hardening agent "A50" = 10/1) was applied in a coating amount of 5 g/m² by a gravure coater. Thereafter, an aluminum deposited polyethylene terephthalate (PET) film of 20 µm in thickness was laminated via the adhesive layer. Thereafter, to the aluminum deposited PET film, the urethane-based adhesive was applied in the same manner and a high weather-resistant fluorine resin film (registered trade mark "TEDLAR" manufactured by Du Pont, thickness: 50 µm) was joined to form a laminate. In this manner, a solar battery back-sheet of a three-layer structure: hydrolysis-resistant polyester film/aluminum deposited PET film/fluorine resin film, was obtained.
Next, a solar battery module was obtained in the same manner as in Example 1.

### [Comparative Example 5]

Onto one of surfaces of a hydrolysis-resistant polyester film "LUMIRROR X10S" (registered trade mark, manufactured by Toray Industries Inc., thickness: 188 µm), a urethane-based adhesive (main agent: "TAKELAC (manufactured by Mitsui Takeda Chemical (registered trade mark)) A511"/hardening agent "A50" = 10/1) was applied in a coating amount of 5 g/m² by a gravure coater. Thereafter, a polychlorotrifluoro ethylene (trifluoride)(PCTFE) film "NEOFLON" (registered trade mark, manufactured by Daikin Industries Ltd., thickness: 25 µm) was laminated via the adhesive-based layer to form a solar battery back-sheet of a two-layer structure: hydrolysis-resistant polyester film /PCTFE film. Next, a solar battery module was obtained in the same manner as in Example 1.

### [Comparative Example 6]

A solar battery back-sheet and a solar battery module were obtained in the same manner as in Example 1 except that acrylic emulsion [k] was used in place of silicone-modified acrylic emulsion [a].

Using the solar battery back-sheets obtained in Examples 1 to 16 and Comparative Examples 1 to 6, the following evaluations were performed.
The results are shown in Table 1 to Table 6.

### <Water-vapor barrier property>

Initial water-vapor barrier property of each of the solar battery back-sheets prepared were evaluated by the MOCON method (PERMATRAN W3/31 manufactured by Modern Control, conditions: 40°C, 90%RH) in accordance with JIS K 7129.
Less than 0.6 g/m².24 hr was indicated by "⊚", 0.6 g/m²·24 hr or more to less than 1.0 g/m²·24 hr by "O", 1.0 g/m²·24 hr or more to less than 1.5 g/m²·24 hr by "Δ" and 1.5 g/m²·24 hr or more by "×".

### <Weather resistance>

Using a sunshine weatherometer (WEL-SUN-DC manufactured by Suga Test Instruments Co., Ltd.), an exposure test (rainfall cycle: 12 minutes/hour, black-panel temperature: 60 to 66°C) was carried out.
As weather resistance (1), appearance after a 2000-hour test was observed.
The case where no change was observed in the surface was indicated by "○", the case where deterioration such as crack/bulge was observed was indicated by "×".

As weather resistance (2), degree of yellow change after a 2000-hour test was observed.
Measurement was performed by a color and color-difference meter "CR-200" manufactured by Konica Minolta Sensing, Inc., in accordance with CIE1976 (JIS Z 8729). The case of the b-value difference (Δb) before and after the exposure test was less than 10 was indicated by "⊚", the case where the b-value difference was 10 or more to less than 20 by "○" and the case where the b-value difference was 20 or more by "×".
As weather resistance (3), water-vapor barrier property was measured after a 2000-hour test. A measuring method and judgment were performed in accordance with the section <Water-vapor barrier property>.

### <Heat resistance>

Based on DIN 40 634, dimension stability at 150°C after 30 minutes was evaluated. The case where no dimensional abnormality was observed was indicated by "○" and the case where dimensional abnormality was observed by "×".

### <Humidity resistance>

As humidity resistance (2000 hours), a test was performed in the conditions of 85°C/85%RH for 2000 hours. As humidity resistance (3000 hours), a test was performed in the conditions of 85°C/85%RH for 3000 hours. The water-vapor barrier property of the samples after each test period was evaluated in the same manner in accordance with JIS K 7129.

Less than 0.6 g/m²·24 hr was indicated by "⊚", 0.6 g/m²·24 hr or more to less than 1.0 g/m²·24 hr by "O", 1.0 g/m²·24 hr or more to less than 1.5 g/m²·24 hr by "Δ" and 1.5 g/m²·24 hr or more by " × ".

### <Electrical insulation property>

Based on IEC 60 664-1, partial discharge voltage performance was evaluated.
Acceptable sample was indicated by "○" and non acceptable sample by "×".

Using the solar battery modules obtained in Examples 1 to 16 and Comparative Examples 1 to 6, the following evaluations were performed.
The results are shown in Table 1 to Table 6.

### <Processability>

A product excellent in processability such as emulsion coating to a plastic base material was indicated by "○", a product poor in processability due to use of a fluorine-based film poor in mechanical strength, was indicated by " × ".

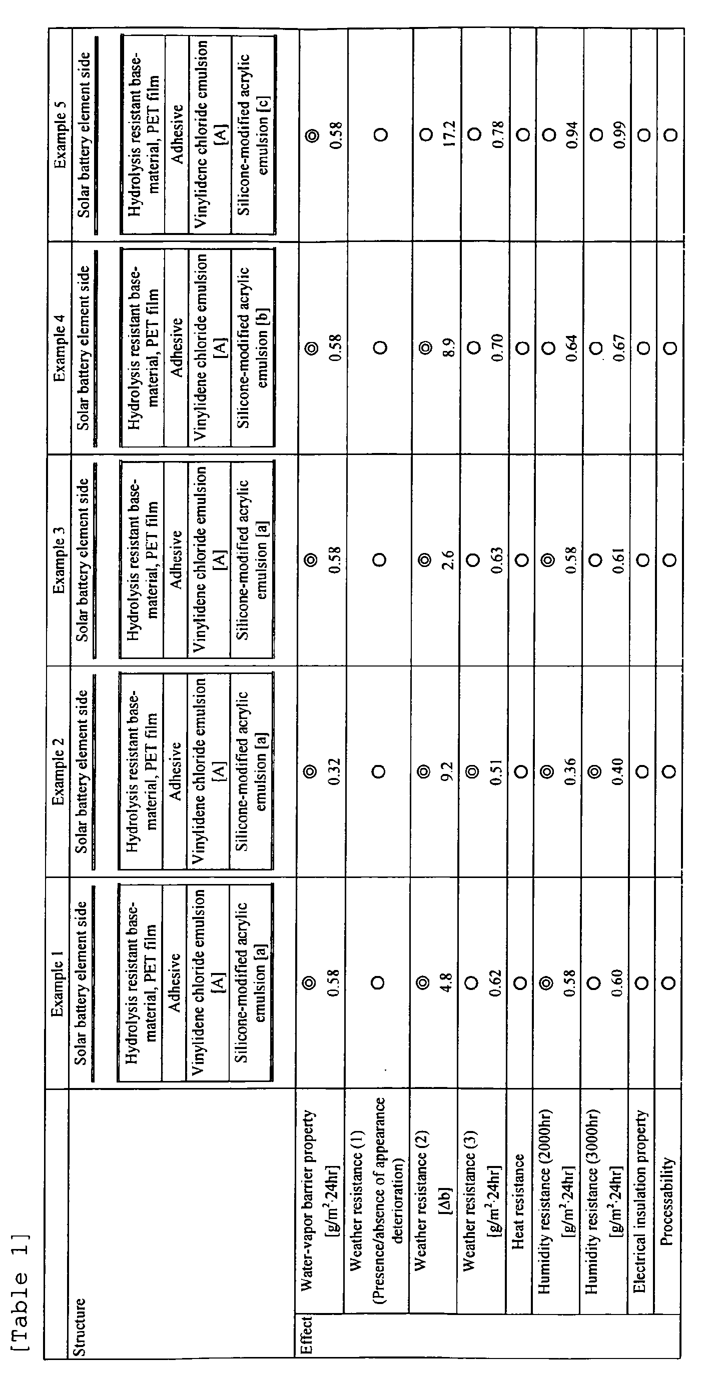

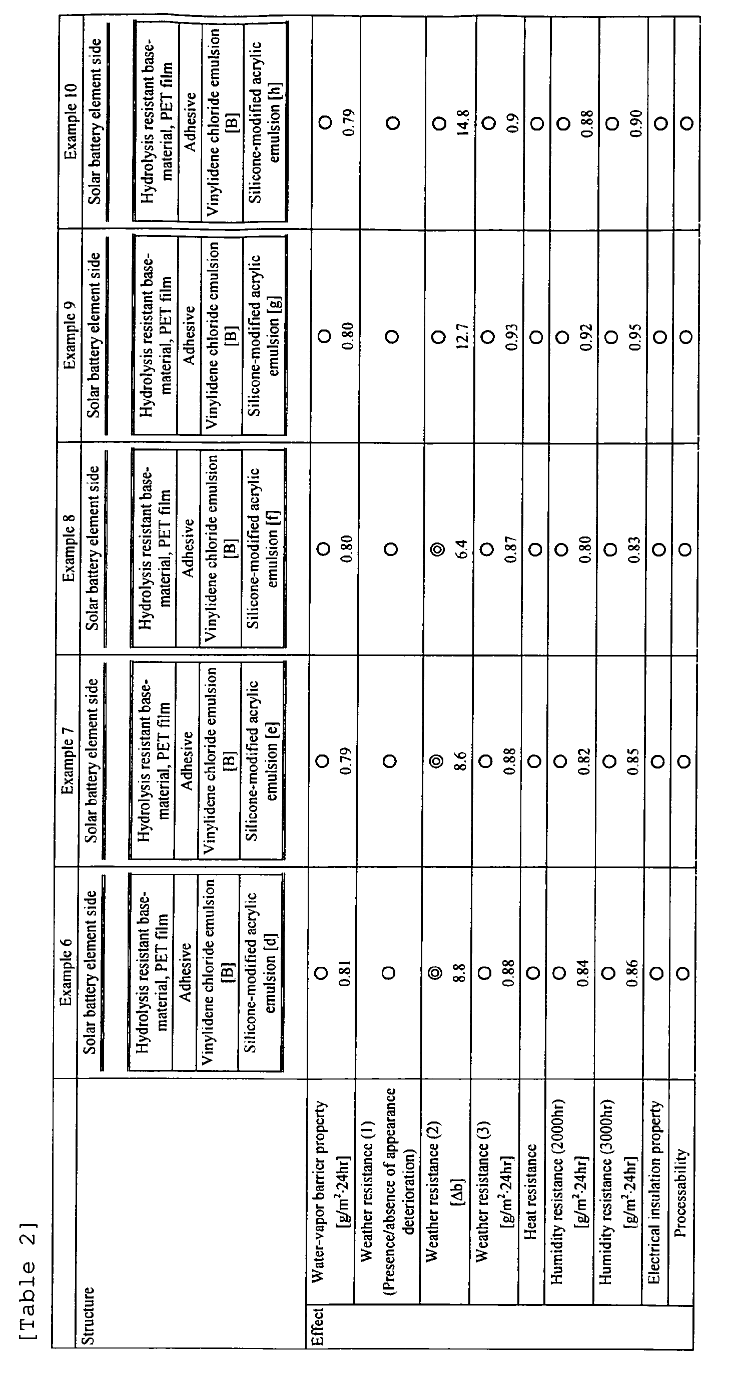

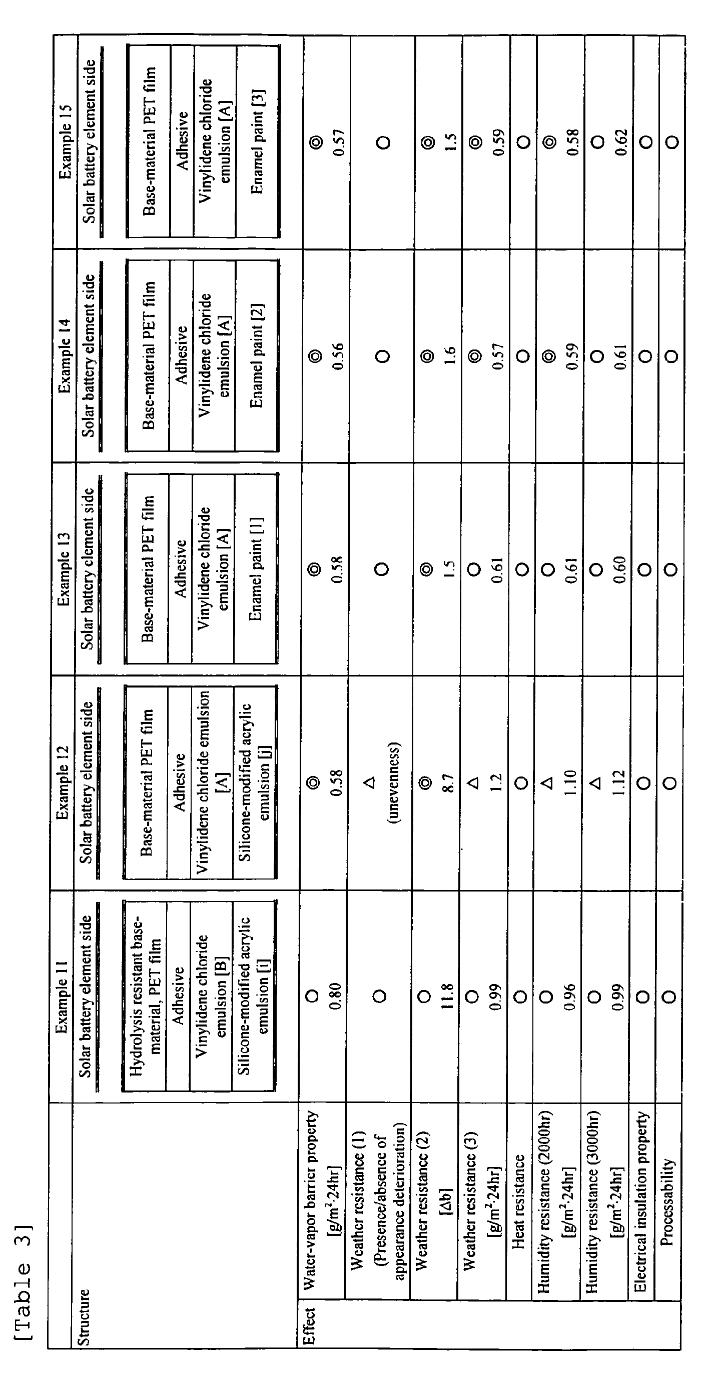

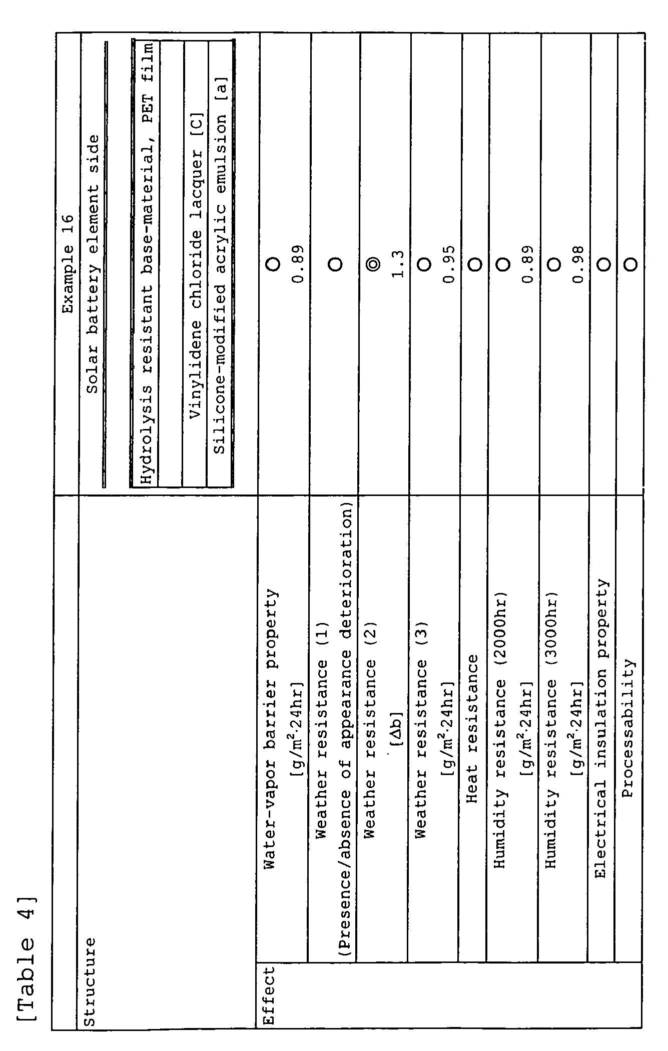

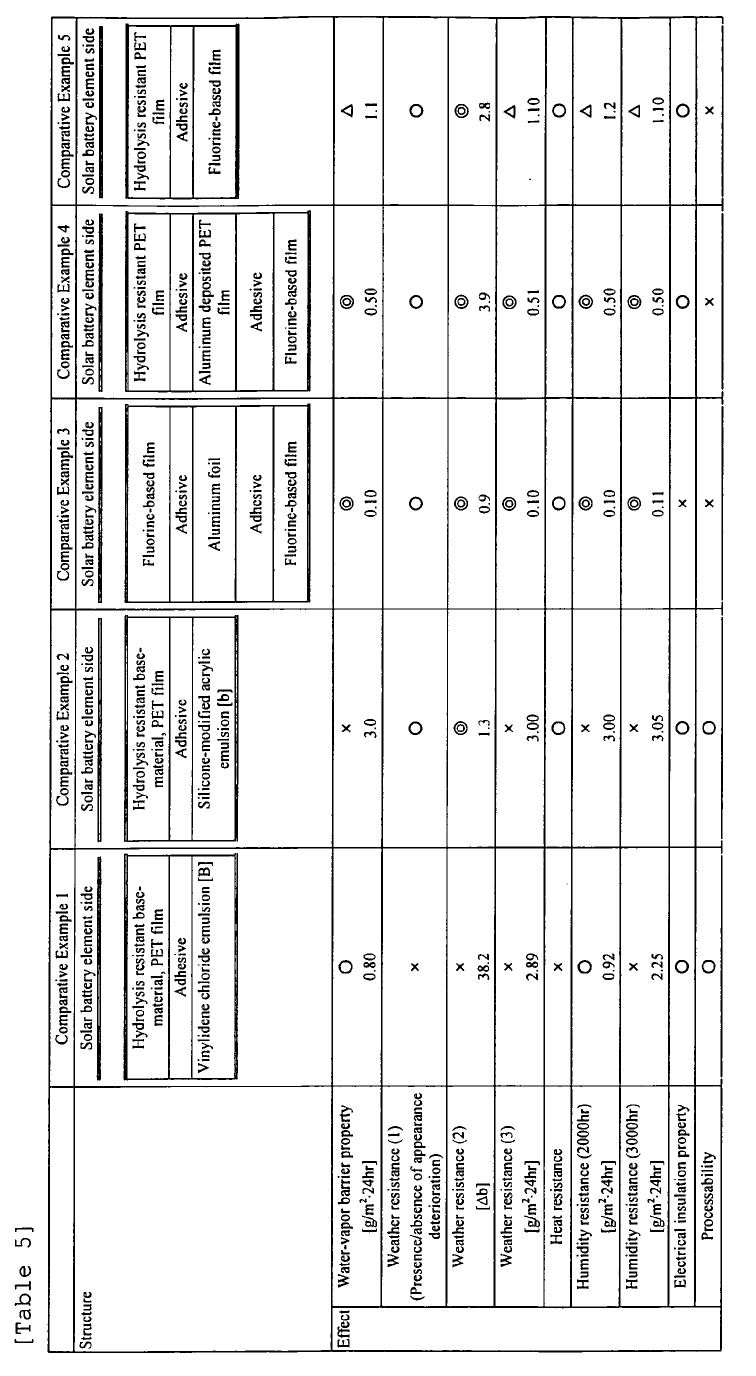

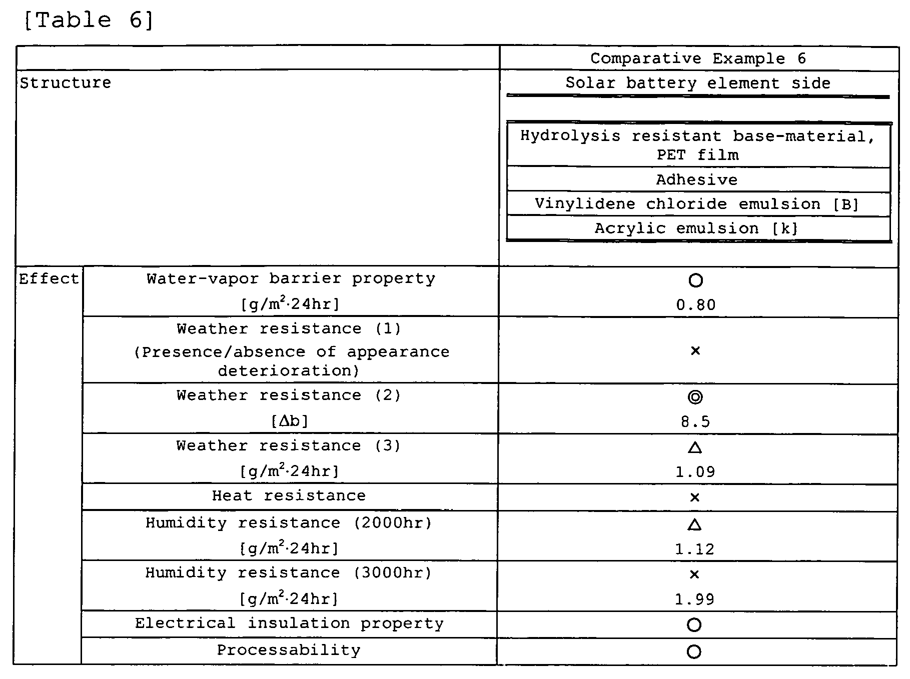

From the results of Table 1 to Table 6, the solar battery back-sheets of Examples 1 to 16 comprising the vinylidene chloride-based resin layer and the silicone-modified acrylic-based resin layer laminated on the vinylidene chloride-based resin layer were each excellent in weather resistance, heat resistance, humidity resistance, water-vapor barrier property and electrical insulation property.
The solar battery back-sheets of Examples 1 to 16, as compared to the solar battery back-sheets of Comparative Examples 1 and 2, comprising either the vinylidene chloride-based resin layer or the silicone-modified acrylic-based resin layer, simultaneously satisfied weather resistance, heat resistance, humidity resistance and water-vapor barrier property, excellently. Particularly, with respect to weather resistance (3) (water-vapor barrier property after the weather resistance test was performed for 2000 hours) and humidity resistance (3000 hours), deterioration in performance was observed in the back sheet comprising either one of the two layers; however, the back sheet comprising both of the two layers sequentially laminated exhibited excellent performance. Furthermore, besides the aforementioned properties, the solar battery back-sheets of Examples 1 to 16 required no adhesive between the vinylidene chloride-based resin layer and the silicone-modified acrylic-based resin layer. Therefore a structure of a member could be more simplified and processability of each layer was excellent.
On the other hand, the solar battery back-sheet of Comparative Example 4 comprising the aluminum deposited PET-based resin layer and the fluorine-based resin layer had a property such as weather resistance required for a solar battery back-sheet; however, an adhesive had to be used between two the resin layers. Therefore, not only a structure of members but also a manufacturing process became complicated and its mechanical strength was insufficient. Thus, processability was poor.

### Industrial Applicability

In the present invention, it is possible to provide a laminate for a solar battery back-sheet excellent in hydrolysis resistance, weather resistance, heat resistance and humidity resistance even under a severe natural environment for a long time, with the result that a high water-vapor barrier property can be exhibited and maintained as well as excellent productivity such as simplicity of member structure and processability can be exhibited.
The solar battery back-sheet and solar battery module of the present invention can be preferably used in the field of a photovoltaic power generation system.

### Reference Signs List

1. Solar battery back-sheet
2. Plastic base
3. Adhesive
4. Vinylidene chloride-based resin layer
5. Silicone-modified acrylic-based resin layer
6. Solar battery module
7. Glass layer
8. Solar battery element
9. Filler

## Claims

1. A laminate for a solar battery back-sheet comprising:
a vinylidene chloride-based resin layer; and
a silicone-modified acrylic-based resin layer laminated on the vinylidene chloride-based resin layer.

2. The laminate for the solar battery back-sheet according to claim 1, wherein the vinylidene chloride-based resin layer and the silicone-modified acrylic-based resin layer are laminated in direct contact with each other.

3. The laminate for the solar battery back-sheet according to claim 1 or 2, wherein the vinylidene chloride-based resin layer is produced from a vinylidene chloride lacquer obtained by dissolving a vinylidene chloride-based resin powder in an organic solvent, or from a vinylidene chloride emulsion.

4. The laminate for the solar battery back-sheet according to claim 3, wherein the vinylidene chloride-based resin powder in the vinylidene chloride lacquer and the vinylidene chloride emulsion are obtained by emulsion polymerization of a monomer containing not less than 50% by mass of vinylidene chloride based on the total amount of the monomer.

5. The laminate for the solar battery back-sheet according to any one of claims 1 to 4, wherein the silicone-modified acrylic-based resin layer is produced from a silicone-modified acrylic emulsion.

6. The laminate for the solar battery back-sheet according to claim 5, wherein the silicone-modified acrylic emulsion contains a silicone resin and an acrylic resin.

7. The laminate for the solar battery back-sheet according to claim 6, wherein when the acrylic resin is produced by emulsion polymerization, the silicone-modified acrylic emulsion is obtained by adding a silicone modifier in at least any one of the steps of before the emulsion polymerization, during the emulsion polymerization and after the emulsion polymerization.

8. The laminate for the solar battery back-sheet according to any one of claims 5 to 7, wherein a UV ray absorbent and/or a photostabilizer are blended in the silicone-modified acrylic emulsion.

9. The laminate for the solar battery back-sheet according to any one of claims 5 to 8, wherein the silicone-modified acrylic emulsion is blended with a pigment and used as a paint.

10. The laminate for the solar battery back-sheet according to any one of claims 1 to 9, wherein the vinylidene chloride-based resin layer is a coating layer with a vinylidene chloride lacquer or a vinylidene chloride emulsion and the silicone-modified acrylic-based resin layer is a coating layer with a silicone-modified acrylic emulsion.

11. The laminate for the solar battery back-sheet according to claim 10, wherein a thickness of the vinylidene chloride-based resin coating layer is 5 to 50 µm and a thickness of the silicone-modified acrylic-based resin coating layer is 10 to 100 µm.

12. A solar battery back-sheet comprising a base material and the laminate for the solar battery back-sheet according to any one of claims 1 to 11, wherein
the laminate for the solar battery back-sheet is laminated on the base material.

13. The solar battery back-sheet according to claim 12, wherein the base material is a plastic base material.

14. The solar battery back-sheet according to claim 12 or 13, wherein the vinylidene chloride-based resin layer and the base material are laminated with an adhesive interposed between them.

15. The solar battery back-sheet according to claim 13 or 14, wherein the plastic base material is formed of a polyethylene terephthalate-based resin.

16. The solar battery back-sheet according to claim 15, wherein the polyethylene terephthalate-based resin is a hydrolysis resistant resin.

17. A solar battery module comprising the solar battery back-sheet according to any one of claims 12 to 16.
